# EUROPEAN PATENT APPLICATION

(11) **EP 4 742 871 A1**
(43) Date of publication of application: **13.05.2026**
(21) Application number: 25212333.6
(22) Date of filing: 30.10.2025
(51) Int. Cl.: H10K 59/131, H10K 59/80, H10K 59/12, H10K 59/35, H10K 59/40

(54) **DISPLAY PANEL, ELECTRONIC APPARATUS INCLUDING THE SAME, AND VEHICLE INCLUDING THE ELECTRONIC APPARATUS**

(30) Priority: 07.11.2024 KR 20240156883; 16.06.2025 KR 20250078901
(71) Applicant: Samsung Display Co., Ltd., Yongin-si, Gyeonggi-do 17113 (KR)
(72) Inventor: Sung, Taekwang, 17113 Yongin-si, Gyeonggi-do (KR); Yoo, Gina, 17113 Yongin-si, Gyeonggi-do (KR)
(74) Representative: Gulde & Partner

(57) **Abstract**

A display panel (10) includes: a substrate (100) including: a first display area (DA1); and a second display area (DA2) with a predetermined angle therebetween; display elements (OLED1-1 to OLED1-3) arranged spaced from each other in the first display area and the second display area; an encapsulation layer (300) on the display elements (OLED1-1 to OLED1-3); a first refractive layer (BL1) in the first display area (DA1) and the second display area (DA2), and on the encapsulation layer (300); and a second refractive layer (OL) on the first refractive layer (BL1). The second display area (DA2) includes a first area (DA-2B) and a second area (DA-2C) adjacent to the first area (DA2-B). The first refractive layer (BL1) in the first area (DA-2B) includes a first inclined surface, and the first refractive layer (BL1) in the second area (DA-2C) includes a second inclined surface. A first inclination angle of the first inclined surface is less than a second inclination angle of the second inclined surface.

## Description

### BACKGROUND

### 1. Field

Aspects of one or more embodiments of the present disclosure relate to a display panel, an electronic apparatus including the display panel, and a vehicle including the electronic apparatus.

### 2. Description of the Related Art

Mobile electronic apparatuses have been widely used. In addition to compact electronic apparatuses, such as mobile phones, tablet personal computers (PCs) have been widely used as mobile electronic apparatuses.

In order to support various functions, the mobile electronic apparatuses may include a display panel to provide users with visual information, for example, images or videos. As components for driving the display panel have recently become more compact, a proportion of the display panel in an electronic apparatus has gradually increased, and a structure to bend the display panel from a flat state by a certain or predetermined angle has been developed.

The above information disclosed in this background section is for enhancement of understanding of the background of the present disclosure, and therefore, it may contain information that does not constitute prior art.

### SUMMARY

A portion of a display panel may be in a bent state. In this case, an image implemented on some part of the bent portion of the display panel may be reflected and viewed by a user. In this case, the luminance of at least a portion of the reflected image may differ from that of another portion of the reflected image due to a different viewing angles and/or due to incomplete reflection, making it difficult to provide a vivid image to the user.

One or more embodiments of the present disclosure are directed to a display panel on which vivid images may be displayed, an electronic apparatus including the display panel, and a vehicle including the electronic apparatus.

Additional aspects and features will be set forth, in part, in the description that follows, and in part, may be apparent from the description, or may be learned by practicing one or more of the presented embodiments of the present disclosure.

According to one or more embodiments, a display panel according to claim 1 is provided, which includes a substrate including a first display area and a second display area. The first display area and the second display area are connected to each other. The first display area and the second display area are arranged or arrangeable at a certain or predetermined angle or at certain or predetermined angles with respect to each other. The display panel includes a plurality of display elements spaced apart from each other in the first display area and the second display area. The display panel includes an encapsulation layer arranged on the plurality of display elements. The display panel includes a first refractive layer and a second refractive layer. The first refractive layer is arranged in the first display area and the second display area. The first refractive layer is arranged on the encapsulation layer. The second refractive layer is arranged on the first refractive layer. The second refractive layer has a refractive index different from a refractive index of the first refractive layer. The second display area includes a first area and a second area. The first area and the second area are arranged adjacent to each other. A section of the first refractive layer that is arranged in the first area includes a first inclined surface. Another section of the first refractive layer that is arranged in the second area includes a second inclined surface. A first inclination angle of the first inclined surface is less than a second inclination angle of the second inclined surface.

Hence, by providing the first refractive layer with differently aligned inclined surfaces in different areas, light emitted via first refractive lay the can be diffracted in different directions, such that a viewer of the display panel, whose head moves, perceived content shown on the display panel with less changes of luminance.

In the following, possible embodiments are described, which can be combined as desired.

In an embodiment, at least one of the first refractive layer arranged in the first area or the first refractive layer arranged in the second area may include an aperture area. Thus, the section of the first refractive layer that is arranged in the first area and/or the other section of the first refractive layer that is arranged in the second area may include an aperture area. An advantage of this embodiment may be that interference between adjacent pixels, e.g. light emitting elements or display element, can at least be reduced, improving the quality of the displayed image.

In an embodiment, the aperture area may include a first aperture area or first aperture sub-area. The first aperture area may be arranged in the first refractive layer. The first aperture area may correspond to one display element of the plurality of display elements arranged in the first area. The aperture area may include a second aperture area or second aperture sub-area. The second aperture area may be arranged in the first refractive layer. The second aperture area may correspond to one display element arranged of the plurality of display elements in the second area. An advantage of this embodiment may be that display elements in different areas can be prevented from interfering potentially differently.

In an embodiment, a total area of a planar shape of the first aperture area may be less than a total area of a planar shape of the second aperture area. An advantage of this embodiment may be that the amount of light emitted through the respective aperture area is different from the amount of light emitted through another aperture area, thereby improving uniform distribution of luminance even if a view views the different areas under different viewing angles.

In an embodiment, an outermost edge of the first aperture area may be outside an edge of an emission area of the display element corresponding to the first aperture area. An advantage of this embodiment may be that the first aperture area blocks less light emitted from the display element even when it is viewed under an acute angle.

In an embodiment, an outermost edge of the second aperture area may be outside an edge of an emission area of the one display element corresponding to the second aperture area. An advantage of this embodiment may be that the second aperture area blocks less light emitted from the display element even when it is viewed under an acute angle.

In an embodiment, the second aperture area may include a second-1 aperture area or first aperture sub-area. The second aperture area may include a second-2 aperture area or second aperture sub-area. The second-2 aperture area may be arranged inside the first refractive layer may be arranged in the second-1 aperture area. An advantage of this embodiment may be that both aperture sub-areas can form the parts of the respective display element that actually emit light via a gap between the two aperture sub-areas in a desired shape.

In an embodiment, a planar shape of the aperture area may include an island shape or a lattice shape. An advantage of this embodiment may be that the parts of the respective display element that actually emit light along the aperture areas can be a single surface or multiple surfaces, wherein the luminance of the display element can be predetermined by the total surface of the single surface or the multiple surfaces.

In an embodiment, at least one of the first refractive layer having the first inclined surface or the first refractive layer having the second inclined surface may include an island shape. An island shaped part or section of the first refractive layer may have the first inclined surface. Another island shaped part or section of the first refractive layer may have the second inclined surface. An advantage of this embodiment may be that due to the island shape, the inclined surface may be provides at an edge of the island shaped part or section, reducing the amount of surface area of height required for the inclined surfaces.

In an embodiment, the first area may be an area that extends from a point spaced apart from a boundary between the first display area and the second display area by at least 10 %, at least 15 %, up to or at least 20 %, less than 25 % and/or less than 30 % of a total length of the second display area, to a point spaced apart from the boundary between the first display area and the second display area by at least 45 %, at least 50 %, up to or at least 55 %, less than 60% and/or less than 65 % of the total length of the second display area. An advantage of this embodiment may be that it is avoided that an area or section between the first display area and the second display area creates distorted illuminance.

In an embodiment, the second area may be an area that extends from a point spaced apart from a boundary between the first display area and the second display area by at least 45 %, at least 50 %, up to or at least 55 %, less than 60% and/or less than 65 % of a total length of the second display area, to an end of an edge of the second display area. An advantage of this embodiment may be that it is avoided that an area or section between the first display area and the second display area creates distorted illuminance.

In an embodiment, a refractive index of the first refractive layer may be in a range of about 1.4 to about 1.55, for example at least 1.35, at least 1.4, at least 1.45, up to 1.5, up to 1.55 and/or up to 1.6. An advantage of this embodiment may be that the first refractive layer is easy to produce.

In an embodiment, a refractive index of the second refractive layer may be in a range of about 1.65 to about 1.85, for example at least 1.6, at least 1.65, at least 1.7, up to 1.75, up to 1.8, up to 1.85 and/or up to 1.9. An advantage of this embodiment may be that the second refractive layer is easy to produce.

In an embodiment, the display panel may further include an input detection layer between the encapsulation layer and the first refractive layer. An advantage of this embodiment may be that the display panel may allow to operate an electronic apparatus comprising the display panel via touch input.

In an embodiment, the display panel may further include a plurality of wiring. The plurality of wiring may be arranged between the substrate and the display element. At least one of the plurality of wiring may be arranged on the substrate so that at least a portion of a pixel electrode of the display element is inclined. An advantage of this embodiment may be that the inclined surface can be provided in a space saving manner.

In an embodiment, a slope of at least the portion of the pixel electrode increases toward the second area from the first area. An advantage of this embodiment may be that pixel electrode of the display element can be contacted easily in a space saving manner.

In an embodiment, one of the plurality of wiring may overlap the pixel electrode. The overlapping wiring may include a protrusion. The protrusion may extend of protrude, e.g. from another section of the wiring, in a direction different from a longitudinal direction of the one of the plurality of wiring. The direction in which the protrusion extends of protrudes from another section of the wiring may be extend under an angle to the other section of the wiring and or the longitudinal direction. The angle may be between 30 ° and 150 ° and for example at least 30 °, at least 45 °, at least 60 °, at least 75 °, at least or up to 90 °, up to 105 °, up to 120 °, up to 135 ° and/or up to 150 °. The protrusion and the other section of the wiring may be arranged in a mutual plane. The mutual plane may be parallel to a surface of the subtrate that faces the wiring. An advantage of this embodiment may be that display elements can be contacted easily in a space saving manner.

According to one or more embodiments, a display panel may include a substrate including a first display area and a second display area. The first display area and the second display area may be connected to each other. The first display area and the second display area may be arranged or arrangeable at a certain or predetermined angle or certain or predetermined angles with respect to each other. The display panel may include a plurality of display elements. The plurality of display elements may be spaced apart from each other in the first display area and the second display area. The display panel may include an encapsulation layer arranged on the plurality of display elements. The display panel may include a first refractive layer which is arranged in the first area and the second display area and on the encapsulation layer. The display panel may include a second refractive layer which is arranged on the first refractive layer and has a refractive index different from a refractive index of the first refractive layer. The second display area may include a first area and a second area which may be adjacent to each other. At least a portion of a pixel electrode of at least one of the plurality of display elements which may be arranged in at least one of the first area and the second area may be inclined.

In an embodiment, a first refractive angle may be less than a second refractive angle. At least some of light emitted from a display element arranged in the first area may be refracted when passing through the first refractive layer and the second refractive layer, which are arranged in the first area, under the first refractive angle. At least some of light emitted from a display element arranged in the second area may be refracted when passing through the first refractive layer and the second refractive layer, which are arranged in the second area, under the second refractive angle. The first refractive angle and the second refractive angle may be formed by inclined surfaces of the first refractive layer arranged in the first area and the second area. The inclination of the inclined surfaces in the first area may differ from the inclination of the inclined surfaces in the second area.

In an embodiment, a slope of the pixel electrode may increase toward the second area from the first area.

In an embodiment, the display panel may further include a plurality of wiring between the pixel electrode and the substrate.

In an embodiment, at least one of the plurality of wiring which is arranged to correspond to the pixel electrode may include a protrusion protruding in a direction different from a longitudinal direction of one of the plurality of wiring.

In an embodiment, display panel may further include a first aperture area arranged in the first refractive layer and corresponding to one display element arranged in the first area, from among the plurality of display elements, and a second aperture area arranged in the first refractive layer and corresponding to one display element arranged in the first area, from among the plurality of display elements.

In an embodiment, a planar shape of at least one of the first aperture area or the second aperture area may include an island shape or a lattice shape.

According to one or more embodiments, an electronic apparatus according to claim 14 is provided.

According to one or more embodiments, an electronic apparatus may include a display panel. The display panel may be bendable. The electronic apparatus may include a beam splitter. The beam splitter may be arranged on or rest against the display panel. The beam splitter may transmit a first image implemented in a portion of the display panel, and may reflect a second image implemented in another portion of the display panel. The display panel may include a substrate including a first display area and a second display area. The first display area and the second display area may be connected to each other and may be arranged or arrangeable at a or predetermined angle certain or predetermined angles with respect to each other. The display panel may include a plurality of display elements spaced apart from each other in the first display area and the second display area. The display panel may include an encapsulation layer arranged on the plurality of display elements. The display panel may include a first refractive layer which may be arranged in the first area and the second display area and on the encapsulation layer. The display panel may include a second refractive layer which may be arranged on the first refractive layer and may have a refractive index different from a refractive index of the first refractive layer. The second display area may include a first area and a second area. The first and second areas may be adjacent to each other. At least a portion of a pixel electrode of at least one of the plurality of display elements which may be arranged in at least one of the first area and the second area, may be inclined.

In an embodiment, the aperture area may further include a first aperture area arranged in the first refractive layer and corresponding to one display element arranged in the first area, from among the plurality of display elements, and a second aperture area arranged in the first refractive layer and corresponding to one display element arranged in the first area, from among the plurality of display elements.

According to one or more embodiments, a vehicle according to claim 15 is provided.

According to one or more embodiments, a vehicle including an electronic apparatus may include a display panel. For example, the electronic apparatus may include the display panel. The display panel may include a substrate including a first display area and a second display area. The first and second display areas may be connected to each other. The first and second display areas may be arranged or arrangeable at a certain or predetermined angle certain or predetermined angles with respect to each other. The display panel may include a plurality of display elements that may be arranged spaced apart from each other in the first display area and the second display area. The display panel may include an encapsulation layer that may be arranged on the plurality of display elements. The display panel may include a first refractive layer which may be arranged in the first area and the second display area and on the encapsulation layer. The display panel may include a second refractive layer which may be arranged on the first refractive layer and may have a refractive index different from a refractive index of the first refractive layer. The second display area may include a first area and a second area which may be adjacent to each other. At least a portion of a pixel electrode of at least one of the plurality of display elements, which may be arranged in at least one of the first area and the second area, may be inclined.

The certain or predetermined angle may be predetermined by the form or shape of the beam splitter. In particular, an angle between entrance surfaces, which the first and second display areas may respective face when the display panel is arranged on or at the beam splitter, may essentially correspond to the certain or predetermined angle between the first and second display areas.

However, the present disclosure is not limited to the above aspects and features, and the above and additional aspects and features will be set forth, in part, in the detailed description that follows with reference to the drawings, and in part, may be apparent therefrom, or may be learned by practicing one or more of the presented embodiments of the present disclosure.

Some aspects and features of the present disclosure described above may be implemented by using any suitable system, method, computer program, or any suitable combination of the system, the method, and the computer program.

### BRIEF DESCRIPTION OF THE DRAWINGS

The above and other aspects and features of the present disclosure will be more clearly understood from the following detailed description of the illustrative, non-limiting embodiments with reference to the accompanying drawings, in which:
FIG. 1 is a diagram schematically illustrating an exterior of a vehicle according to an embodiment;
FIG. 2A is a diagram schematically illustrating an interior of the vehicle according to an embodiment;
FIG. 2B is a diagram schematically illustrating an interior of the vehicle according to an embodiment;
FIG. 2C is a diagram schematically illustrating an interior of the vehicle according to an embodiment;
FIG. 3A is a cross-sectional view schematically illustrating an electronic apparatus according to an embodiment;
FIG. 3B is a perspective view schematically illustrating a display panel according to an embodiment;
FIG. 3C is a plan view schematically illustrating the display panel according to an embodiment;
FIG. 4 is a block diagram schematically illustrating an electronic apparatus including the display panel shown in FIG. 3B;
FIGS. 5A and 5B are cross-sectional views schematically illustrating an electronic apparatus according to some embodiments;
FIG. 6 is an equivalent circuit diagram schematically illustrating a sub-pixel according to an embodiment;
FIG. 7A is a plan view schematically illustrating an emission area of a display element and a first refractive layer, which are in a connection area shown in FIGS. 3A to 3C;
FIG. 7B is a plan view schematically illustrating the emission area of the display element and the first refractive layer, which are in a first area shown in FIGS. 3A to 3C;
FIG. 7C is a plan view schematically illustrating the emission area of the display element and the first refractive layer, which are in a second area shown in FIGS. 3A to 3C;
FIG. 8 is a cross-sectional view schematically illustrating the display elements shown in FIGS. 7A, 7B, and 7C;
FIGS. 9A and 9B are cross-sectional views schematically illustrating an order of a method of manufacturing the display panel shown in FIG. 8;
FIGS. 10A and 10B are plan views schematically illustrating a first-3 emission area of a first-3 display element and the first refractive layer, which are arranged in the second area of the display panel, according to some embodiments;
FIG. 11 is a cross-sectional view schematically illustrating a portion of a display panel according to an embodiment;
FIG. 12 is a plan view schematically illustrating locations of an emission area and a wiring, which are in the second area of the display panel shown in FIG. 11;
FIG. 13 is a plan view schematically illustrating a portion of a display panel according to an embodiment; and
FIG. 14 is a cross-sectional view taken along the line D-D' of FIG. 13.

### DETAILED DESCRIPTION

Hereinafter, embodiments will be described in more detail with reference to the accompanying drawings, in which like reference numbers refer to like elements throughout. The present disclosure, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art. Accordingly, processes, elements, and techniques that are not necessary to those having ordinary skill in the art for a complete understanding of the aspects and features of the present disclosure may not be described. Unless otherwise noted, like reference numerals denote like elements throughout the attached drawings and the written description, and thus, redundant description thereof may not be repeated.

When a certain embodiment may be implemented differently, a specific process order may be different from the described order. For example, two consecutively described processes may be performed at the same or substantially at the same time, or may be performed in an order opposite to the described order.

Further, as would be understood by a person having ordinary skill in the art, in view of the present disclosure in its entirety, each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner, unless otherwise stated or implied.

In the drawings, the relative sizes, thicknesses, and ratios of elements, layers, and regions may be exaggerated and/or simplified for clarity. Spatially relative terms, such as "beneath," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly.

Further, it should be expected that the shapes shown in the figures may vary in practice depending, for example, on tolerances and/or manufacturing techniques. Accordingly, the embodiments of the present disclosure should not be construed as being limited to the specific shapes shown in the figures, and should be construed considering changes in shapes that may occur, for example, as a result of manufacturing. As such, the shapes shown in the drawings may not depict the actual shapes of areas of the device, and the present disclosure is not limited thereto.

In the figures, the x-axis, the y-axis, and the z-axis are not limited to three axes of the rectangular coordinate system, and may be interpreted in a broader sense. For example, the x-axis, the y-axis, and the z-axis may be perpendicular to or substantially perpendicular to one another, or may represent different directions from each other that are not perpendicular to one another.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the present disclosure.

It will be understood that when an element or layer is referred to as being "on," "connected to," or "coupled to" another element or layer, it can be directly on, connected to, or coupled to the other element or layer, or one or more intervening elements or layers may be present. Similarly, when a layer, an area, or an element is referred to as being "electrically connected" to another layer, area, or element, it may be directly electrically connected to the other layer, area, or element, and/or may be indirectly electrically connected with one or more intervening layers, areas, or elements therebetween. In addition, it will also be understood that when an element or layer is referred to as being "between" two elements or layers, it can be the only element or layer between the two elements or layers, or one or more intervening elements or layers may also be present.

The terminology used herein is for the purpose of describing particular embodiments and is not intended to be limiting of the present disclosure. As used herein, the singular forms "a" and "an" are intended to include the plural forms as well, unless the context clearly indicates otherwise. It will be further understood that the terms "comprises," "comprising," "includes," "including," "has," "have," and "having," when used in this specification, specify the presence of the stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items. For example, the expression "A and/or B" denotes A, B, or A and B. Expressions such as "at least one of," when preceding a list of elements, modify the entire list of elements and do not modify the individual elements of the list. For example, the expression "at least one of a, b, or c," "at least one of a, b, and c," and "at least one selected from the group consisting of a, b, and c" indicates only a, only b, only c, both a and b, both a and c, both b and c, all of a, b, and c, or variations thereof.

As used herein, the term "substantially," "about," and similar terms are used as terms of approximation and not as terms of degree, and are intended to account for the inherent variations in measured or calculated values that would be recognized by those of ordinary skill in the art. Further, the use of "may" when describing embodiments of the present disclosure refers to "one or more embodiments of the present disclosure." As used herein, the terms "use," "using," and "used" may be considered synonymous with the terms "utilize," "utilizing," and "utilized," respectively.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

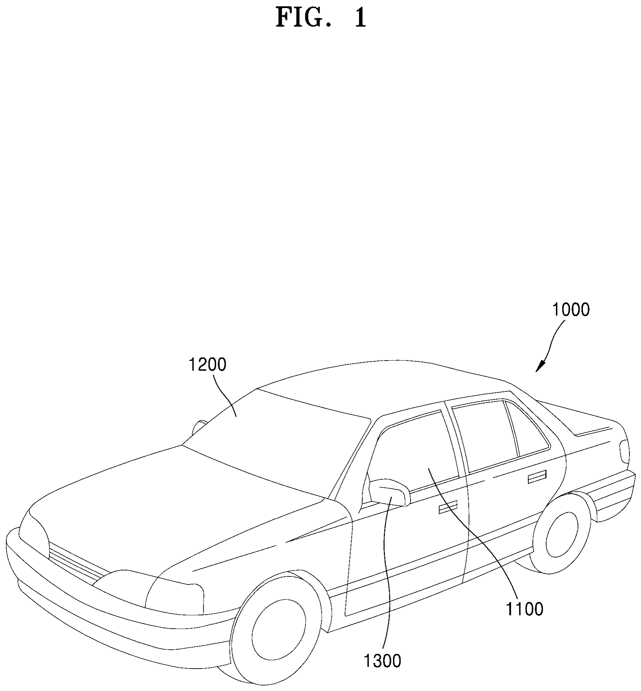

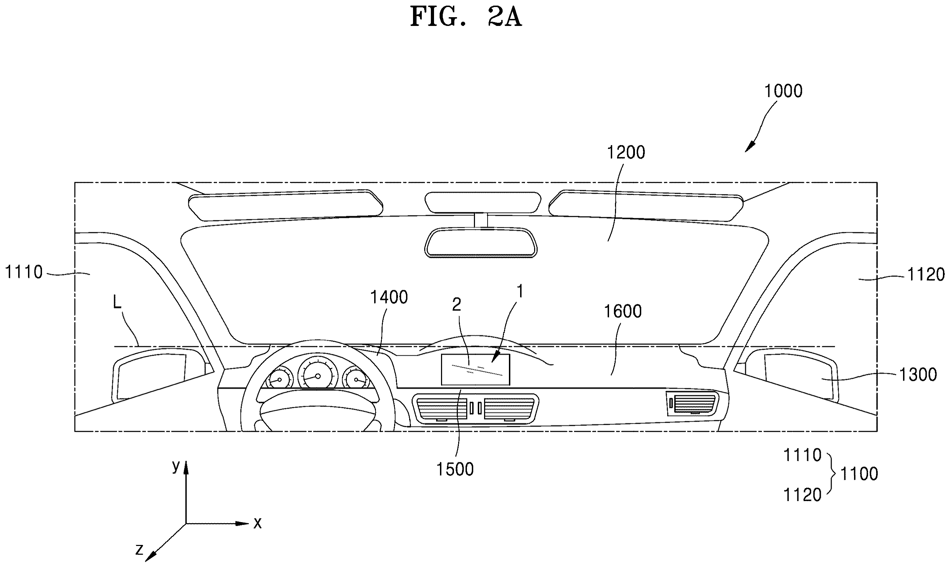

FIG. 1 is a diagram schematically illustrating an exterior of a vehicle 1000 according to an embodiment. FIGS. 2A through 2C are diagrams schematically illustrating an interior of the vehicle 1000 according to various embodiments.

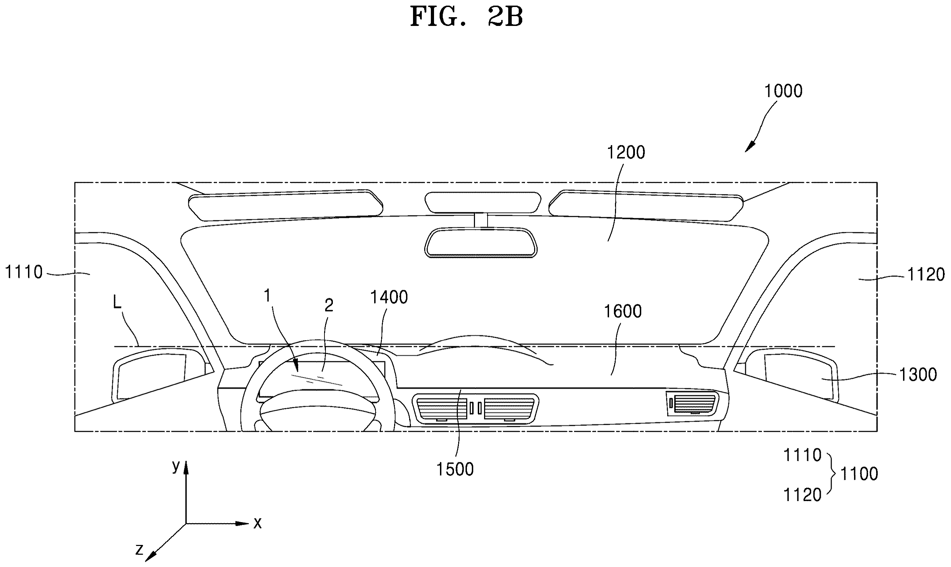

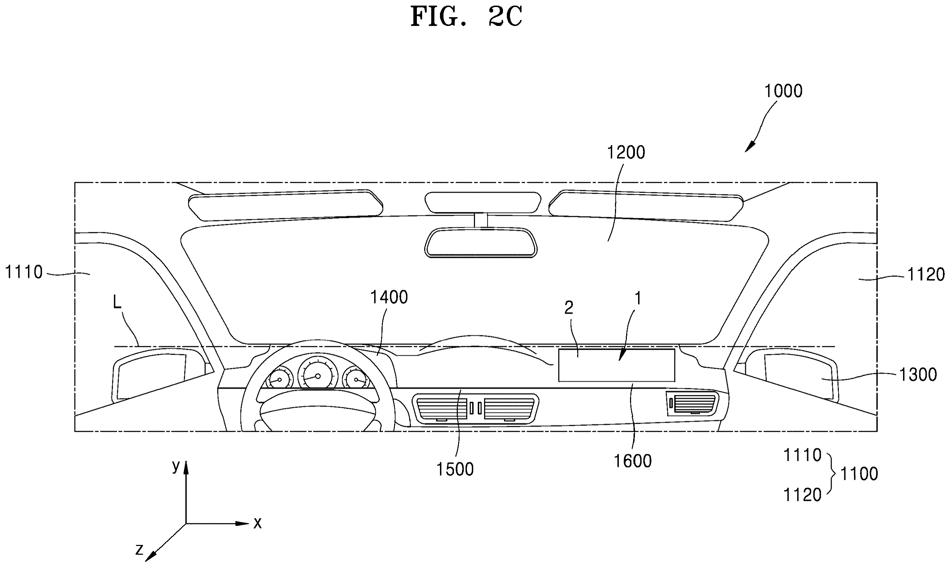

Referring to FIGS. 1, 2A, 2B, and 2C, the vehicle 1000 may refer to various suitable apparatuses that transport a payload, such as a human, an object, or an animal, from a starting point to a destination. The vehicle 1000 may include any suitable kind of ground vehicles that travel on a road or a track, ships that move on a sea or a river, airplanes that fly in the air by using the action of the air, or the like. For convenience of illustration, the vehicle 1000 is described in more detail hereinafter in the context of a ground vehicle as a representative example.

The vehicle 1000 may move in a desired direction (e.g., a certain or predetermined direction) according to a rotation of at least one wheel. For example, the vehicle 1000 may include a three-wheeled or four-wheeled vehicle, construction equipment, a two-wheeled vehicle, a motorized device, a bicycle, a driving robot, and/or a train running on a track.

The vehicle 1000 may include a vehicle body having an interior and an exterior, and a chassis on which mechanical devices used for driving are installed, excluding the vehicle body. The exterior of the vehicle body may include a front panel, a bonnet, a loop panel, a rear panel, a trunk, and a filler provided at a boundary between doors. The chassis of the vehicle 1000 may include a power generation device, a power transmission device, a driving device, a steering device, a braking device, a suspension device, a transmission device, a fuel device, front, rear, left, and right wheels, and/or the like.

The vehicle 1000 may include a side window glass 1100, a front window glass 1200, a side-view mirror 1300, a cluster 1400, a center fascia 1500, and a passenger dashboard 1600.

The side window glass 1100 and the front window glass 1200 may be partitioned by a filler arranged between the side window glass 1100 and the front window glass 1200.

The side window glass 1100 may be installed on a side surface of the vehicle 1000. In an embodiment, the side window glass 1100 may be installed on a door of the vehicle 1000. The side window glass 1100 may be provided in a plurality, and the plurality of side window glasses 1100 may face each other. In an embodiment, the side window glass 1100 may include a first side window glass 1110 and a second side window glass 1120. In an embodiment, the first side window glass 1110 may be arranged adjacent to the cluster 1400. The second side window glass 1120 may be arranged adjacent to the passenger dashboard 1600.

In an embodiment, pieces of the side window glass 1100 may be spaced apart from each other in an x or -x direction. For example, the first side window glass 1110 and the second side window glass 1120 may be spaced apart from each other in the x or -x direction. In other words, an imaginary straight line L connecting or extending through the pieces of the side window glass 1100 may extend in the x or -x direction. For example, the imaginary straight line L connecting or extending through the first side window glass 1110 and the second side window glass 1120 may extend in the x or -x direction.

The front window glass 1200 may be installed at a front of the vehicle 1000. The front window glass 1200 may be arranged between the pieces of the side window glass 1100 that face each other.

The side-view mirror 1300 may provide a rear view of the vehicle 1000. The side-view mirror 1300 may be installed on the exterior of the vehicle body. In an embodiment, the side-view mirror 1300 may be provided in a plurality. One of the plurality of side-view mirrors 1300 may be arranged outside the first side window glass 1110. Another one of the plurality of side-view mirrors 1300 may be arranged outside the second side window glass 1120.

The cluster 1400 may be located in front of a steering wheel. The cluster 1400 may include a tachometer, a speedometer, a coolant temperature gauge, a fuel gauge, a turn signal indicator, a high beam indicator, a warning light, a seat belt warning light, an odometer, an odograph, an automatic transmission selector indicator, a door open warning light, an engine oil warning light, and/or a low fuel warning light.

The center fascia 1500 may include an audio device, an air conditioning device, and a control panel on which a plurality of buttons for adjusting seat heaters are disposed. The center fascia 1500 may be arranged on one side of the cluster 1400.

The passenger dashboard 1600 may be spaced apart from the cluster 1400, with the center fascia 1500 between the passenger dashboard 1600 and the cluster 1400. In an embodiment, the cluster 1400 may be arranged to correspond to a driver seat, and the passenger dashboard 1600 may be arranged to correspond to a passenger seat. In an embodiment, the cluster 1400 may be adjacent to the first side window glass 1110, and the passenger dashboard 1600 may be adjacent to the second side window glass 1120.

The side window glass 1100, the front window glass 1200, the side-view mirror 1300, the cluster 1400, the center fascia 1500, and/or the passenger dashboard 1600 may include an electronic apparatus 1.

In an embodiment, the electronic apparatus 1 may include a display panel, a beam splitter, and a transmissive window 2. Images may be displayed on the display panel. The electronic apparatus 1 may be arranged inside the vehicle 1000. The transmissive window 2 may include a transparent material, and may transmit light reflected from and/or passing through the beam splitter. In an embodiment, the electronic apparatus 1 may be arranged between the pieces of the side window glass 1100 that face each other. The electronic apparatus 1 may be arranged on at least one of the cluster 1400, the center fascia 1500, or the passenger dashboard 1600.

The display panel may include liquid crystal display panels, electrophoretic display panels, organic light-emitting display panels, inorganic light-emitting display panels, field emission display panels, surface-conduction electron-emitter display panels, quantum dot display panels, plasma display panels, cathode ray display panels, or the like. Hereinafter, an organic light-emitting display panel may be described in more detail as a representative example of the display panel according to an embodiment. However, the present disclosure is not limited thereto, and in an embodiment, display panels of various suitable methods and configurations as described above may be used.

Referring to FIG. 2A, the electronic apparatus 1 may be arranged on the center fascia 1500. In an embodiment, the electronic apparatus 1 may display navigation information. In an embodiment, the electronic apparatus 1 may display information about an audio, a video, or vehicle settings.

In an embodiment, light emitted from the electronic apparatus 1 may travel in a suitable direction (e.g., a particular or predetermined direction). For example, light emitted from the electronic apparatus 1 may travel toward the driver seat. Light emitted from the electronic apparatus 1 may travel toward the passenger seat. Light emitted from the electronic apparatus 1 may not travel to the front window glass 1200.

Referring to FIG. 2B, the electronic apparatus 1 may be arranged on the cluster 1400. In this case, the cluster 1400 may express driving information or the like by using the electronic apparatus 1. For example, the cluster 1400 may be implemented digitally. The cluster 1400 of the digital kind may display vehicle information and driving information as images. For example, a needle and a gauge of a tachometer and various warning light icons may be displayed by using digital signals.

In an embodiment, light emitted from the electronic apparatus 1 may travel in a suitable direction (e.g., a particular or predetermined direction). For example, light emitted from the electronic apparatus 1 may travel toward the driver seat.

Referring to FIG. 2C, the electronic apparatus 1 may be arranged on the passenger dashboard 1600. The electronic apparatus 1 may be embedded in the passenger dashboard 1600, or may located on the passenger dashboard 1600. In an embodiment, the electronic apparatus 1 arranged on the passenger dashboard 1600 may display information displayed on the cluster 1400 and/or the center fascia 1500. In another embodiment, the electronic apparatus 1 arranged on the passenger dashboard 1600 may display information that is different from the information displayed on the cluster 1400 and/or the center fascia 1500.

In an embodiment, light emitted from the electronic apparatus 1 may travel in a suitable direction (e.g., a particular or predetermined direction). For example, light emitted from the electronic apparatus 1 may travel toward the passenger seat. As another example, light emitted from the electronic apparatus 1 may not travel toward the driver seat. As another example, light emitted from the electronic apparatus 1 may not travel to the second side window glass 1120.

In some embodiments, light emitted from the electronic apparatus 1 arranged on the passenger dashboard 1600 may not travel to the front window glass 1200. Thus, the driver's forward driving view may not be obstructed by the electronic apparatus 1 arranged on the passenger dashboard 1600.

However, the electronic apparatus 1 as described above is not limited thereto, and may be a device for displaying moving images or still images. The electronic apparatus 1 may include various suitable portable electronic devices, such as mobile phones, smartphones, tablet personal computers (PCs), mobile communication terminals, electronic notebooks, electronic books, portable multimedia players (PMPs), navigations, or ultra mobile PCs (UMPCs), or various suitable products, such as televisions, laptops, monitors, billboards, or Internet of things (IoT) devices. In some embodiments, the electronic apparatus 1 may include various suitable wearable devices, such as smart watches, watch phones, glasses-type displays, or head-mounted displays (HMDs). In some embodiments, the electronic apparatus 1 may be arranged on the rear surface of a front seat for entertainment for a rear seat in the vehicle.

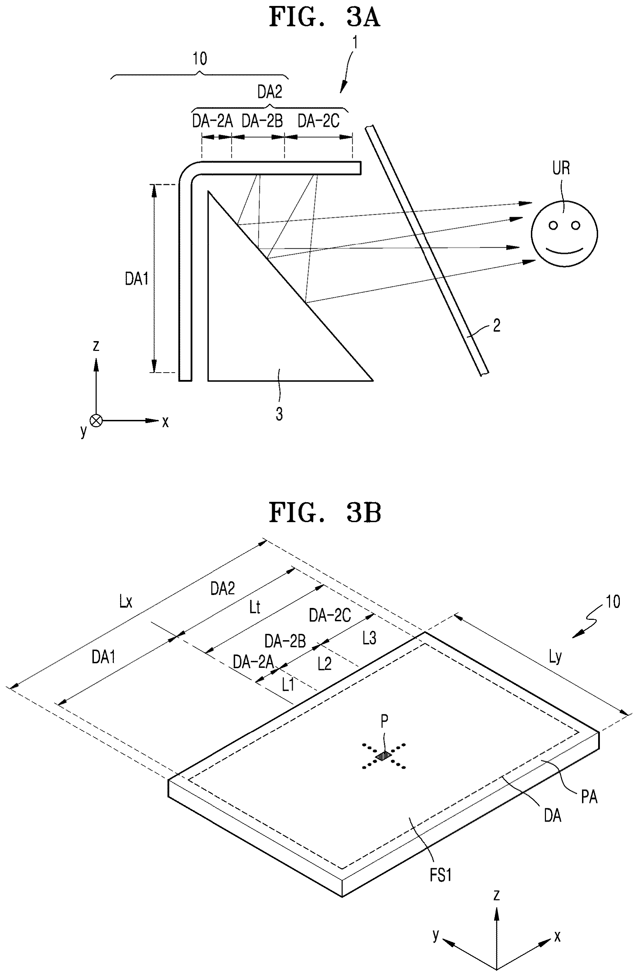

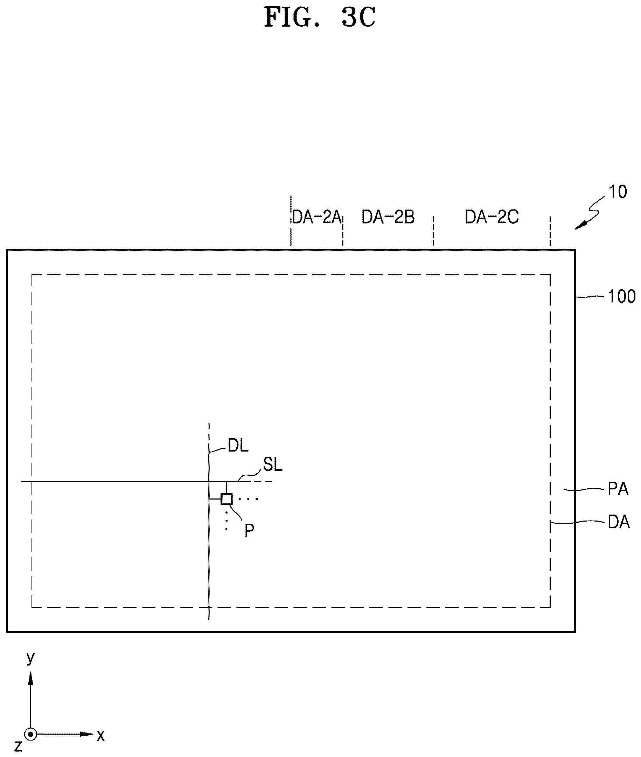

FIG. 3A is a cross-sectional view schematically illustrating the electronic apparatus 1 according to an embodiment. FIG. 3B is a perspective view schematically illustrating a display panel 10 according to an embodiment. FIG. 3C is a plan view schematically illustrating the display panel 10 according to an embodiment.

Referring to FIGS. 3A, 3B, and 3C, the electronic apparatus 1 may include the display panel 10, a beam splitter 3, and the transmissive window 2.

The display panel 10 may include a substrate 100, and a multi-layered film above the substrate 100. A display area DA and a peripheral area PA may be defined in the substrate 100 and/or the multi-layered film. For example, the substrate 100 may include the display area DA and the peripheral area PA. Hereinafter, for convenience of illustration, the display area DA and the peripheral area PA are described as being defined in the substrate 100 as a representative example. A sub-pixel P may be arranged in the display area DA. A plurality of sub-pixels P may display images. Each of the plurality of sub-pixels P may be connected to a corresponding scan line SL that extends in a first direction (e.g., the x or -x direction), and a corresponding data line DL that extends in a second direction (e.g., the y or -y direction). In an embodiment, the sub-pixel P may be arranged on a front surface FS1 of the display panel 10.

The sub-pixel P may be implemented as a display element. The display panel 10 may provide images by using light emitted from the sub-pixel P. The light emitted from the sub-pixel P may travel in one direction from the front surface FS1 of the display panel 10. The light emitted from the sub-pixel P may not travel in another direction from the front surface FS1 of the display panel 10. In an embodiment, the light emitted from the sub-pixel P may travel in a direction that is perpendicular to or substantially perpendicular to the front surface FS1 of the display panel 10 (e.g., a z direction). The light emitted from the sub-pixel P may travel in a direction that is oblique to the front surface FS1 of the display panel 10 (e.g., a direction crossing the z direction). The light emitted from the sub-pixel P may not include a component in at least one of the x direction or the y direction.

In an embodiment, the sub-pixel P may emit one of a red light, a green light, or a blue light by using a display element. In an embodiment, the sub-pixel P may emit one of a red light, a green light, a blue light, or a white light by using the display element. In an embodiment, the sub-pixel P may be defined as an emission area of the display element that emits light of any one color among red, green, blue, or white.

In an embodiment, the sub-pixel P may include a light-emitting diode as a display element that is capable of emitting light of a desired color (e.g., a certain or predetermined color). The light-emitting diode may include an organic light-emitting diode, which includes an organic material as an emission layer. In some embodiments, the light-emitting diode may include an inorganic light-emitting diode. In some embodiments, the light-emitting diode may include quantum dots as an emission layer. In an embodiment, a size of the light-emitting diode may be on a microscale or a nanoscale. For example, the light-emitting diode may be a microlight-emitting diode. In some embodiments, the light-emitting diode may be a nano-light-emitting diode. The nano-light-emitting diode may include gallium nitride (GaN). In an embodiment, a color conversion layer may be arranged on the nano-light-emitting diode. The color conversion layer may include quantum dots. For convenience of illustration, the light-emitting diode may be described in more detail as including an organic light-emitting diode as a representative example.

The peripheral area PA may be arranged outside the display area DA. The peripheral area PA may surround (e.g., around a periphery of) the display area DA at least in part. In an embodiment, the peripheral area PA may surround (e.g., around a periphery of) the display area DA entirely. A scan driver that provides a scan signal to each of the sub-pixels P may be arranged in the peripheral area PA. A data driver that provides a data signal to the sub-pixel P may be arranged in the peripheral area PA. The peripheral area PA may include a pad area. In an embodiment, a pad may be arranged in the pad area. The pad may be exposed rather than being covered by an insulating layer, and may be electrically connected to a printed circuit board or a driver integrated circuit (IC). Through the pad, signals and/or voltages received from the printed circuit board or the driver IC may be transferred to the sub-pixel P arranged in the display area DA through a wiring connected to the pad.

The display panel 10 may be bent at least in part. In this case, the display panel 10 may include the display area DA in which images are displayed. The display area DA may include a first display area DA1 and a second display area DA2, which are connected to each other and are arranged to form a desired angle (e.g., a certain or predetermined angle) therebetween. In this case, a bending area may exist between the first display area DA1 and the second display area DA2. The bending area may be a portion of the first display area DA1 or a portion of the second display area DA2. For convenience of illustration, the bending area described in more detail below may be a portion of the second display area DA2 as a representative example.

The second display area DA2 may include a connection area DA-2A connected to the first display area DA1, a first area DA-2B connected to the connection area DA-2A, and a second area DA-2C connected to the first area DA-2B. In this case, the connection area DA-2A may be arranged on the farthest side from a user UR, and the second area DA-2C may be arranged on the closest side of the user UR. In addition, the first area DA-2B may be arranged between the connection area DA-2A and the second area DA-2C. In this case, light emitted from each of the areas may take different paths. For example, light emitted from the first display area DA1 and the connection area DA-2A may travel in a straight line. At least some of the light emitted from the first area DA-2B and the second area DA-2C may form an angle (e.g., a certain or predetermined angle) with respect to a direction perpendicular to or substantially perpendicular to a surface of the second display area DA2 (e.g., the z direction in FIG. 3B). For example, the angle formed by at least some of the light emitted from the first area DA-2B with respect to the direction perpendicular to or substantially perpendicular to the surface of the second display area DA2 may be less than the angle formed by at least some of the light emitted from the second area DA-2C with respect to the direction perpendicular to or substantially perpendicular to the surface of the second display area DA2.

In this case, a first length L1 of the connection area DA-2A measured in the first direction (e.g., the x direction in FIG. 3B) may be approximately 20 % of a total length Lt of the second display area DA2. A second length L2 of the first area DA-2B may be approximately 35 % of the total length Lt of the second display area DA2. A third length L3 of the second area DA-2C may be approximately 45 % of the total length Lt of the second display area DA2. The total length Lt of the second display area DA2 may be a length from a boundary between the first display area DA1 and the second display area DA2 to an edge of the second display area DA2. In addition, the first length L1, the second length L2, and the third length L3 may indicate a distance between boundaries of each area.

The peripheral area PA may be an area where no images are provided. The peripheral area PA may surround (e.g., around a periphery of) the display area DA at least in part. In an embodiment, the peripheral area PA may surround (e.g., around a periphery of) the display area DA entirely. In the peripheral area PA, a driver or the like for providing electrical signals or power to the sub-pixel P may be arranged. In addition, the peripheral area PA may include a pad area in which a pad is arranged.

The display panel 10 may include an edge. In an embodiment, the display panel 10 may include at least one edge. For example, the display panel 10 may have a polygonal shape. In another example, the display panel 10 may have a circular shape or an elliptical shape. In another example, the edge of the display panel 10 may include a curve. Hereinafter, the display panel 10 having a rectangular shape may be mainly described in more detail as a representative example.

The display panel 10 may include a first edge Lx and a second edge Ly. The first edge Lx may be an edge of the display panel 10 that extends in the x or -x direction. The second edge Ly may be an edge of the display panel 10 that extends in the y or -y direction. In an embodiment, the first edge Lx and the second edge Ly may be different from each other in length. For example, the first edge Lx may be greater in length than that of the second edge Ly. As another example, the first edge Lx may be less in length than that of the second edge Ly. In another embodiment, the first edge Lx and the second edge Ly may be equal to or substantially equal to each other in length.

The beam splitter 3 may be arranged between the first display area DA1 and the second display area DA2. The beam splitter 3 may transmit images implemented in the first display area DA1, and may reflect images implemented in the second display area DA2. The user UR may view one image through the beam splitter 3. In this case, the image viewed by the user may be in a three-dimensional form or in a two-dimensional form.

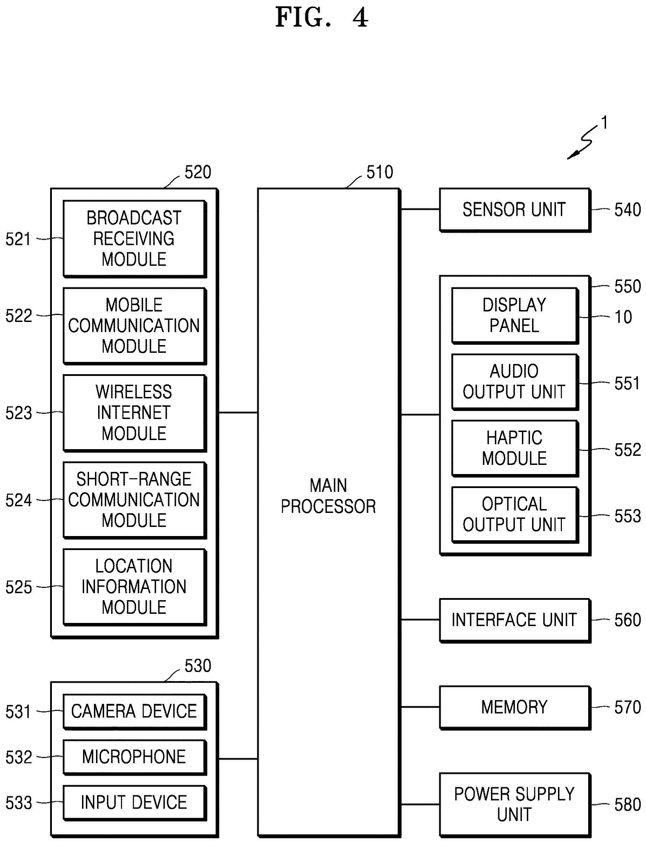

FIG. 4 is a block diagram schematically illustrating the electronic apparatus 1 including the display panel 10 shown in FIG. 3B.

Referring to FIG. 4, the electronic apparatus 1 may include a main processor 510, a wireless communication unit 520, an input unit 530, a sensor unit 540, an output unit 550, an interface unit 560, a memory 570, and/or a power supply unit 580.

The wireless communication unit 520 may include at least one of a broadcast receiving module 521, a mobile communication module 522, a wireless Internet module 523, a short-range communication module 524, or a location information module 525.

The broadcast receiving module 521 may receive broadcast signals and/or broadcast-related information from an external broadcast management server via a broadcast channel. The broadcast channel may include satellite channels or terrestrial channels.

The mobile communication module 522 may transmit/receive wireless signals to/from a base station, an external terminal, and an external server, on a mobile communication network established according to technical standards or communication schemes for mobile communications (e.g., Global System for Mobile communication (GSM), Code Division Multi Access (CDMA), Code Division Multi Access 2000 (CDMA2000), Enhanced Voice-Data Optimized or Enhanced Voice-Data Only (EV-DO), Wideband CDMA (WCDMA), High Speed Downlink Packet Access (HSDPA), High Speed Uplink Packet Access) (HSUPA), Long Term Evolution (LTE), Long Term Evolution-Advanced (LTE-A), or the like). The wireless signals may include voice call signals, video call signals, or various suitable forms of data according to text/multimedia message transmission and reception.

The wireless Internet module 523 may provide wireless Internet access. The wireless Internet module 523 may transmit/receive wireless signals in a communication network according to wireless Internet technologies. For example, the wireless Internet technologies may include Wireless Local Area Network (WLAN), Wireless-Fidelity (Wi-Fi), Wi-Fi Direct, and/or Digital Living Network Alliance (DLNA).

The short-range communication module 524 may be for short-range communications, and may support short-range communications by using at least one of Bluetooth^{™}, Radio Frequency Identification (RFID), Infrared Data Association (IrDA), Ultra Wideband (UWB), ZigBee, Near Field Communication (NFC), Wi-Fi, Wi-Fi Direct, or Wireless Universal Serial Bus (Wireless USB) technologies. Through the short-range Wireless Area Networks, the short-range communication module 524 may support wireless communications between the electronic apparatus 1 and a wireless communication system, between the electronic apparatus 1 and another electronic apparatus, or between the electronic apparatus 1 and a network in which the other electronic apparatus (or external server) is located. The short-range Wireless Area Networks may be short-range Wireless Personal Area Networks. The other electronic apparatus may be a wearable device that may mutually exchange data (or may be interlocked) with the electronic apparatus 1.

The location information module 525 may obtain a location of the electronic apparatus 1, and may include a Global Positioning System (GPS) module or a Wi-Fi module.

The input unit 530 may include at least one of an image input unit for inputting image signals, such as a camera device 531, an audio input unit for inputting audio signals, such as a microphone 532, or an input device 533 for receiving an input of information from a user. The camera device 531 may process image frames, such as still images or moving images, obtained by an image sensor in a video call mode or a shooting mode. The processed image frames may be displayed on the display panel 10, or may be stored in the memory 570. The microphone 532 may process an external audio signal into electrical speech data. The processed speech data may be variously utilized according to the functions being performed (e.g., the applications running) on the electronic apparatus 1.

The main processor 510 may control the operations of the electronic apparatus 1 to correspond to information received via the input device 533. The input device 533 may include a mechanical input means, such as a button, a dome switch, a jog wheel, or a jog switch, located on a rear surface or a side surface of the electronic apparatus 1, or a touch input means. The touch input means may include a touchscreen layer of the display panel 10.

The sensor unit 540 may include one or more sensors to sense at least one of information in the electronic apparatus 1, surrounding environment information of the electronic apparatus 1, or user information, and may generate a sensing signal corresponding to the sensed information. Based on the sensing signal, the main processor 510 may control a driving or an operation of the electronic apparatus 1, or may perform data processing, functions, or operations related to applications installed on the electronic apparatus 1. The sensor unit 540 may be a proximity sensor, an illumination sensor, or a face recognition sensor, related to a component. In some embodiments, the sensor unit 540 may include an acceleration sensor, a magnetic sensor, a G-sensor, a gyroscope sensor, a motion sensor, an RGB sensor, an infrared (IR) sensor, a finger scan sensor, an ultrasonic sensor, an optical sensor, and/or a battery gauge. In addition, the sensor unit 540 may include an environmental sensor or a chemical sensor. For example, the environmental sensor may be a barometer, a hygrometer, a thermometer, a radiation detection sensor, a heat detection sensor, and/or a gas detection sensor. The chemical sensor may be an electronic nose, a healthcare sensor, and/or a biometric sensor.

The output unit 550 is for generating an output related to vision, hearing, or tactile sensations, and may include at least one of the display panel 10, an audio output unit 551, a haptic module 552, or an optical output unit 553.

The display panel 10 may display (e.g., may output) information processed in the electronic apparatus 1. For example, the display panel 10 may display execution screen information of an application running on the electronic apparatus 1, a user interface (UI) according to the execution screen information, or graphical user interface (GUI) information. The display panel 10 may include a display layer that displays images, and the touchscreen layer that detects a touch input of a user. As such, the display panel 10 may function as one of the input devices 533 that provide an input interface between the electronic apparatus 1 and the user, while also functioning as one of the output units 550 that provide an output interface between the electronic apparatus 1 and the user.

In a call signal reception mode, a call mode, a recording mode, a speech recognition mode, and/or a broadcast reception mode, the audio output unit 551 may output audio data received from the wireless communication unit 520 or stored in the memory 570. The audio output unit 551 may output audio signals related to functions (e.g., a call signal reception sound, a message reception sound, or the like) performed in the electronic apparatus 1. The audio output unit 551 may include a receiver and a speaker. At least one of the receiver or the speaker may be an audio generating device, which is attached to a lower portion of the display panel 10, and may vibrate the display panel 10 and output sound. The audio generating device may be a piezoelectric element or piezoelectric actuator, which shrinks and expands according to electric signals, or an exciter that generates a magnetic force by using a voice coil and vibrates the display panel 10.

The haptic module 552 may generate various suitable tactile effects that may be felt by a user. The haptic module 552 may provide a vibration to the user as a tactile effect. The haptic module 552 may not only deliver a tactile effect through a direct contact, but may also be implemented so that a user may feel the tactile effect through a muscle sense of his/her fingers or arms.

The optical output unit 553 may output a signal for notifying the occurrence of an event, by using light from a light source. Examples of an event occurring in the electronic apparatus 1 may include receiving a message, receiving a call signal, receiving a missed call, an alarm, a schedule reminder, receiving an e-mail, and/or receiving information through an application. A signal output from the optical output unit 553 may be implemented as the electronic apparatus 1 emits light of one or more colors from the front or rear. The signal output may be terminated when the electronic apparatus 1 detects the user's acknowledgement of the event.

The interface unit 560 may serve as a passage for various suitable kinds of external devices connected to the electronic apparatus 1. The interface unit 560 may include at least one of a wired/wireless headset port, an external charger port, a wired/wireless data port, a memory card port, a port that connects a device having an identification module, an audio input/output (I/O) port, a video I/O port, or an earphones port. When an external device is connected to the interface unit 560, the electronic apparatus 1 may perform an appropriate control related to the connected external device.

The memory 570 may store data for supporting various suitable functions of the electronic apparatus 1. The memory 570 may store a plurality of application programs running on the electronic apparatus 1, data for operations of the electronic apparatus 1, and/or instructions. At least some of the plurality of applications may be downloaded from an external server through a wireless communication. The memory 570 may store applications for operating the main processor 510, or may temporarily store input/output data, such as a phonebook, messages, still images, and/or moving images. In addition, the memory 570 may store haptic data for a vibration of various patterns provided to the haptic module 552, and audio data regarding various sounds provided to the audio output unit 551.

The memory 570 may include at least one kind of storage medium among a flash memory, a hard disk, a solid state disk (SSD), a silicon disk drive (SDD), a multimedia card micro, a card-kind of memory (e.g., Secure Digital (SD) or eXtreme Digital (XD) memory), random access memory (RAM), static random access memory (SRAM), read-only memory (ROM), electrically erasable programmable read-only memory (EEPROM), programmable read-only memory (PROM), magnetic memory, a magnetic disk, or an optical disk.

Under the control by the main processor 510, the power supply unit 580 may receive external power and/or internal power, and may supply the power to each of the elements included in the electronic apparatus 1.

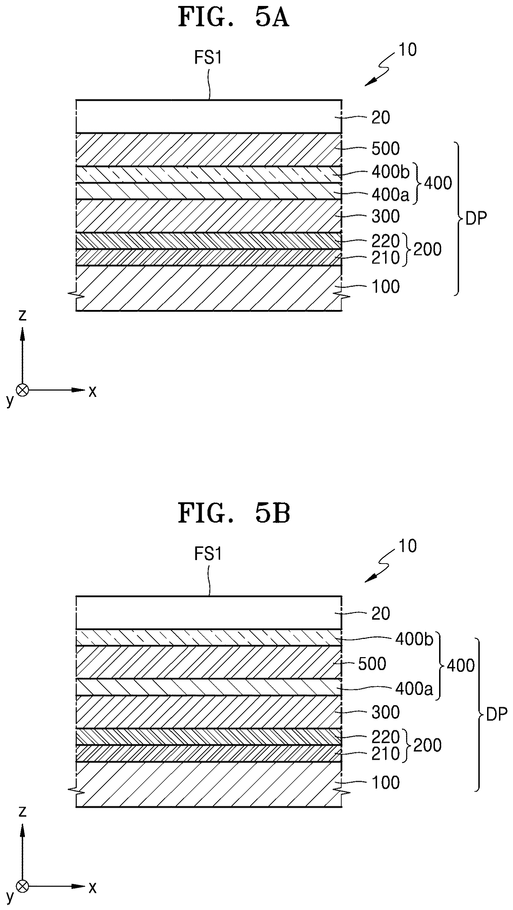

FIGS. 5A and 5B are cross-sectional views schematically illustrating an electronic apparatus according to some embodiments.

Referring to FIGS. 5A and 5B, the display panel 10 may include a display panel unit DP and a cover window 20. The display panel unit DP may include the substrate 100, a display layer 200, an encapsulation layer 300, a functional layer 400, and an anti-reflection layer 500.

The substrate 100 may include a polymer resin, such as polyethersulfone, polyarylate, polyetherimide, polyethylene naphthalate, polyethylene terephthalate, polyphenylene sulfide, polyimide, polycarbonate, and/or cellulose acetate propionate. In an embodiment, the substrate 100 may be a multi-layered structure that includes a base layer including the polymer resin, and a barrier layer. The substrate 100 that includes a polymer resin may have flexible, rollable, or bendable characteristics.

The display layer 200 may be arranged on the substrate 100. The display layer 200 may include a pixel circuit layer 210 and a display element layer 220. The pixel circuit layer 210 may include a plurality of pixel circuits. The display element layer 220 may include a plurality of display elements respectively connected to the plurality of pixel circuits. In an embodiment, the plurality of display elements may be spaced from each other in the first display area DA1 and the second display area DA2. Each of the display elements provided in the display element layer 220 may define a sub-pixel. The pixel circuit layer 210 may include a plurality of thin-film transistors and a plurality of storage capacitors.

The encapsulation layer 300 may be arranged on the display layer 200. In an embodiment, the encapsulation layer 300 may include at least one inorganic encapsulation layer and at least one organic encapsulation layer. The at least one inorganic encapsulation layer may include one or more inorganic materials among aluminum oxide (Al₂O₃), titanium oxide (TiO₂), tantalum oxide (Ta₂O₅), zinc oxide (ZnO), silicon oxide (SiO₂), silicon nitride (SiNₓ), and/or silicon oxynitride (SiON). The at least one organic encapsulation layer may include a polymer-based material. The polymer-based material may include an acryl-based resin, an epoxy-based resin, polyimide, polyethylene, or the like. In an embodiment, the at least one organic encapsulation layer may include an acrylate.

In another embodiment, the encapsulation layer 300 may have a structure in which the substrate 100 and an upper substrate, which is transparent, are coupled to each other by a sealing member, so that an internal space between the substrate 100 and the upper substrate is sealed. A moisture absorbent, a filler, or the like may be located in the internal space. The sealing member may be a sealant, and in an embodiment, the sealing member may include a suitable material that is curable by laser. For example, the sealing member may be a frit. For example, the sealing member may include a urethane-based resin, an epoxy-based resin, and/or an acryl-based resin, which are organic sealants, or silicone, which is an inorganic sealant. For example, the urethane-based resin may include urethane acrylate or the like. For example, the acryl-based resin may include butyl acrylate, ethylhexyl acrylate, or the like. In some embodiments, the sealing member may include a suitable material that is curable by heat.

The functional layer 400 may be arranged on the encapsulation layer 300. The functional layer 400 may include a first layer 400a and a second layer 400b. In an embodiment, at least one of the first layer 400a or the second layer 400b may include an input detection layer, which is a touch sensor layer. The touch sensor layer, which senses a touch input of a user, may detect the touch input of the user by using at least one of various suitable touch methods, such as a resistive film method or a capacitive method. In an embodiment, at least one of the first layer 400a or the second layer 400b may include an optical layer. In an embodiment, the optical layer may have a suitable structure for controlling a direction of light emitted from the display elements.

In an embodiment, the functional layer 400 may be provided, such that a partial configuration of the touch sensor layer and a partial configuration of the optical layer are shared with each other. For example, the functional layer 400 may be a touch sensor layer capable of sensing a touch input, and an optical layer capable of improving an optical performance.

Referring to FIG. 5A, the anti-reflection layer 500 may be arranged above the functional layer 400. The anti-reflection layer 500 may reduce a reflectivity of light (e.g., external light) incident toward the display panel unit DP from the outside.

In an embodiment, the anti-reflection layer 500 may be provided as a polarizing film. The polarizing film may include linear polarizing plates or phase retardation films, such as a quarter-wave (λ/4) plate. The phase retardation film may be arranged on the functional layer 400, and the linear polarizing plate may be arranged on the phase retardation film.

In an embodiment, the anti-reflection layer 500 may include a light-shielding layer and/or a filter layer, which includes color filters. The color filters may be arranged considering the colors of light emitted from the sub-pixels. For example, the filter layer may include a red color filter, a green color filter, or a blue color filter.

In an embodiment, when the anti-reflection layer 500 includes the light-shielding layer and/or the color filters, the anti-reflection layer 500 may be arranged between the first layer 400a and the second layer 400b, as shown in FIG. 5B. In this case, the configuration of the anti-reflection layer 500 and the configuration of the optical layer may be shared with each other.

The cover window 20 may be arranged on the display panel unit DP. In an embodiment, the cover window 20 may be coupled to at least one of the elements located below (e.g., under) the cover window 20, such as the anti-reflection layer 500 or the functional layer 400, through an adhesive, such as an optically clear adhesive (OCA). The cover window 20 may protect the display panel unit DP. The cover window 20 may include at least one of glass, sapphire, or a plastic. The cover window 20 may be, for example, an ultra-thin glass (UTG) and/or a colorless polyimide (CPI).

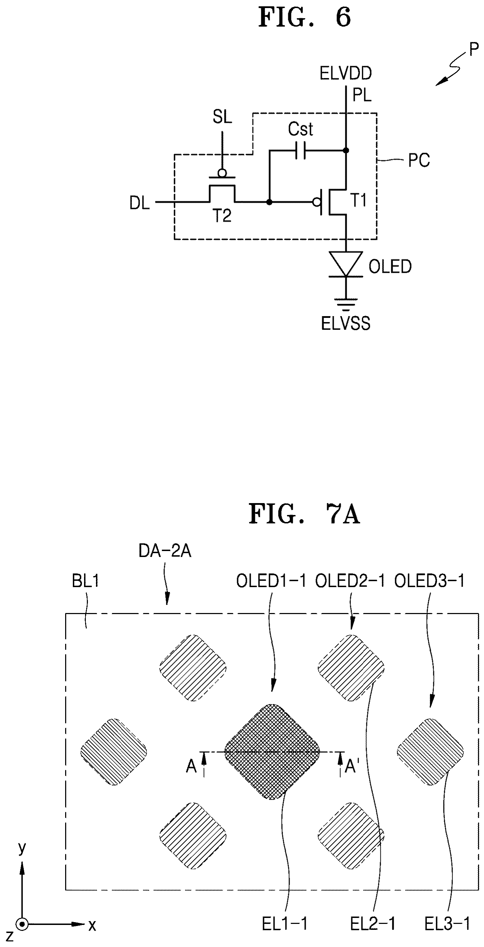

FIG. 6 is an equivalent circuit diagram schematically illustrating the sub-pixel P according to an embodiment.

Referring to FIG. 6, the sub-pixel P may include a pixel circuit PC, and an organic light-emitting diode OLED as a display element.

The pixel circuit PC may include a driving transistor T1, a switching thin-film transistor T2, and a storage capacitor Cst. For example, each sub-pixel P may emit one of a red light, a green light, or a blue light, or one of a red light, a green light, a blue light, or a white light, through the organic light-emitting diode OLED.

The switching thin-film transistor T2 may be connected to the scan line SL and the data line DL, and may transfer data signals or data voltages received via the data line DL to the driving transistor T1 based on scan signals or switching voltages received via the scan line SL. The storage capacitor Cst may be connected to the switching thin-film transistor T2 and a driving voltage line PL, and may store a voltage corresponding to a voltage difference between a voltage received from the switching thin-film transistor T2 and a first power voltage ELVDD supplied to the driving voltage line PL.

The driving transistor T1 may be connected to the driving voltage line PL and the storage capacitor Cst, and may control a driving current that flows from the driving voltage line PL to the organic light-emitting diode OLED to correspond to a voltage value stored in the storage capacitor Cst. The organic light-emitting diode OLED may emit light having a desired luminance (e.g., a certain or predetermined luminance) according to the driving current. A common electrode (e.g., a cathode) of the organic light-emitting diode OLED may receive a second power voltage ELVSS.

FIG. 7A is a plan view schematically illustrating an emission area of a display element and a first refractive layer, which are in the connection area DA-2A shown in FIGS. 3A to 3C.

Referring to FIG. 7A, a plurality of display elements may be arranged in the connection area DA-2A. For example, the plurality of display elements may include a first-1 display element OLED1-1 which is a first display element, a second-1 display element OLED2-1 which is a second display element, and a third-1 display element OLED3-1 which is a third display element. In this case, each of the display elements may correspond to one sub-pixel. The display elements may emit light of different colors from each other. For example, the first-1 display element OLED1-1 may emit a blue light, the second-1 display element OLED2-1 may emit a green light, and the third-1 display element OLED3-1 may emit a red light. In this case, the second-1 display element OLED2-1 and the third-1 display element OLED3-1 may be arranged to be symmetrical to or substantially symmetrical to each other with respect to the first-1 display element OLED1-1. For example, as shown in FIG. 7A, four second-1 display elements OLED2-1 may be symmetrical to or substantially symmetrical to each other with respect to the first-1 display element OLED1-1. In addition, two third-1 display elements OLED3-1 may be arranged to be symmetrical to or substantially symmetrical to each other with respect to the first-1 display element OLED1-1.

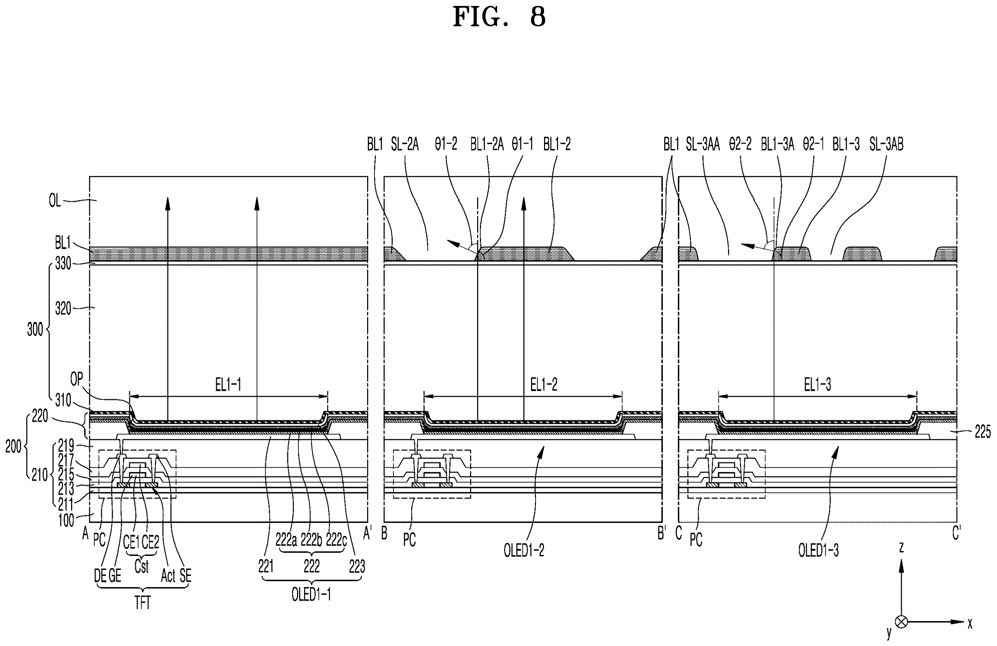

The display elements may include an emission area. The emission area may indicate an area where each of the display elements emits light of a desired color, and may be defined as a flat or substantially flat shape that exposes an emission layer 222b (e.g., see FIG. 8) by a bank layer 225, which is described in more detail below with reference to FIG. 8.

The first-1 display element OLED1-1 may include a first-1 emission area EL1-1, the second-1 display element OLED2-1 may include a second-1 emission area EL2-1, and the third-1 display element OLED3-1 may include a third-1 emission area EL3-1.

A first refractive layer BL1 may be arranged on the first-1 display element OLED1-1, the second-1 display element OLED2-1, and the third-1 display element OLED3-1 to completely shield the first-1 display element OLED1-1, the second-1 display element OLED2-1, and the third-1 display element OLED3-1. For example, the first refractive layer BL1 may be arranged to completely shield the first-1 emission area EL1-1, the second-1 emission area EL2-1, and the third-1 emission area EL3-1. In this case, the first refractive layer BL1 may be arranged to entirely cover the first display area DA1 and the connection area DA-2A described above with reference to FIGS. 3A to 3C.

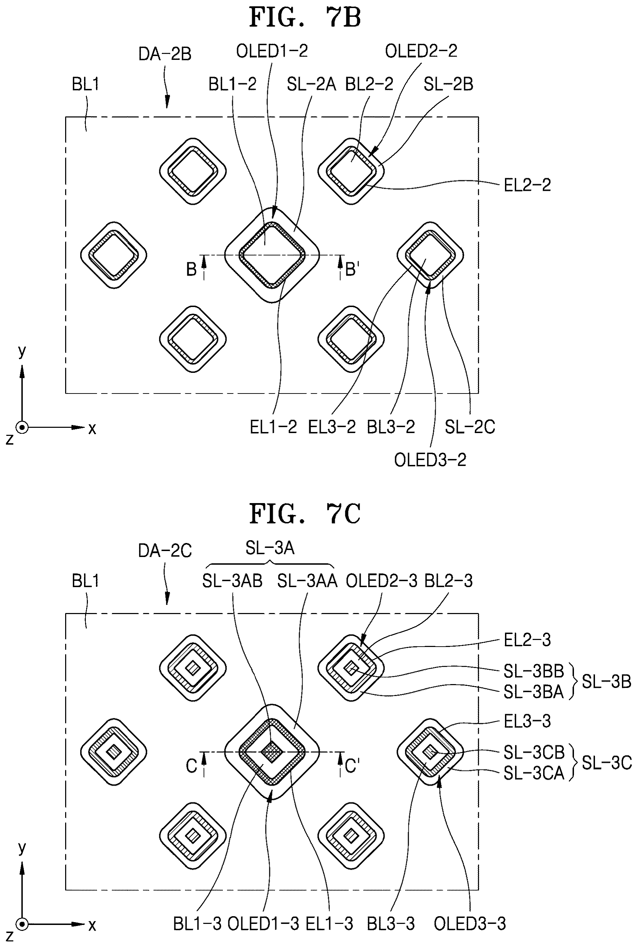

FIG. 7B is a plan view schematically illustrating the emission area of the display element and the first refractive layer, which are arranged in the first area DA-2B shown in FIGS. 3A to 3C.

Referring to FIG. 7B, a plurality of display elements may be arranged in the first area DA-2B. For example, the plurality of display elements may include a first-2 display element OLED1-2, a second-2 display element OLED2-2, and a third-2 display element OLED3-2. The first-2 display element OLED1-2, the second-2 display element OLED2-2, and the third-2 display element OLED3-2 may be the same or substantially the same as (or similar to) the first-1 display element OLED1-1, the second-1 display element OLED2-1, and the third-1 display element OLED3-1 described above with reference to FIG. 7A, respectively, and thus, redundant description thereof may not be repeated hereinafter. Each of the display elements may include an emission area. For example, the first-2 display element OLED1-2 may include a first-2 emission area EL1-2, the second-2 display element OLED2-2 may include a second-2 emission area EL2-2, and the third-2 display element OLED3-2 may include a third-2 emission area EL3-2. Because the first-2 emission area EL1-2, the second-2 emission area EL2-2, and the third-2 emission area EL3-2 may be the same or substantially the same as (or similar to) the first-1 emission area EL1-1, the second-1 emission area EL2-1, and the third-1 emission area EL3-1 described above with reference to FIG. 7A, respectively, redundant description thereof may not be repeated hereinafter.

The first refractive layer BL1 may be arranged on the display element as described above. The first refractive layer BL1 may include first aperture areas to correspond to respective display elements arranged in the first area DA-2B. For example, the first refractive layer BL1 may include a first-2 aperture area SL-2A corresponding to the first-2 display element OLED1-2, a second-2 aperture area SL-2B corresponding to the second-2 display element OLED2-2, and a third-2 aperture area SL-2C corresponding to the third-2 display element OLED3-2. The first aperture areas corresponding to the respective display elements may have a planar shape that is the same or substantially the same as (or similar to) planar shapes of the emission areas of the respective display elements. The planar shapes of the respective first aperture areas may be formed to be greater than the planar shapes of the emission areas of the respective display elements. For example, the first aperture areas may expose at least a portion of the respective emission areas to the outside. In this case, the planar shapes of the respective emission areas may be arranged inside the planar shapes of the first aperture areas, respectively. For example, the planar shape of the first-2 emission area EL1-2 may be arranged inside the planar shape of the first-2 aperture area SL-2A, the planar shape of the second-2 emission area EL2-2 may be arranged inside the planar shape of the second-2 aperture area SL-2B, and the planar shape of the third-2 emission area EL3-2 may be arranged inside the planar shape of the third-2 aperture area SL-2C. In this case, edges of the respective first aperture areas may be spaced apart from edges of the respective emission areas, respectively.

The first refractive layer BL1 may include island layers arranged in the respective aperture areas. Planar shapes of the island layers arranged in the respective first aperture areas may be the same or substantially the same as (or similar to) planar shapes of respective first aperture areas, respectively. In addition, edges of the planar shapes of the respective first aperture areas may be spaced apart from edges of the planar shapes of the respective island layers, respectively. The edges of the planar shape of the respective island layers may be spaced apart from the edges of the planar shapes of the first aperture areas respectively corresponding to the island layers and the edges of the planar shapes of the respective emission areas. In addition, the planar shapes of the island layers may be arranged inside the planar shapes of the emission areas corresponding to the respective island layers and the planar shapes of the respective first aperture areas.

The first refractive layer BL1 may include a first-2 island layer BL1-2 arranged inside the first-2 aperture area SL-2A, a second-2 island layer BL2-2 arranged inside the second-2 aperture area SL-2B, and a third-2 island layer BL3-2 arranged inside the third-2 aperture area SL-2C. Each of the first-2 island layer BL1-2, the second-2 island layer BL2-2, and the third-2 island layer BL3-2 may be disconnected from the first refractive layer BL1 by the first-2 aperture area SL-2A, the second-2 aperture area SL-2B, and the third-2 aperture area SL-2C, respectively.

FIG. 7C is a plan view schematically illustrating the emission area of the display element and the first refractive layer, which are in the second area DA-2C shown in FIGS. 3A to 3C.

Referring to FIG. 7C, a plurality of display elements may be arranged in the second area DA-2C. For example, the plurality of display elements may include a first-3 display element OLED1-3, a second-3 display element OLED2-3, and a third-3 display element OLED3-3. The first-3 display element OLED1-3, the second-3 display element OLED2-3, and the third-3 display element OLED3-3 may be the same or substantially the same as (or similar to) the first-1 display element OLED1-1, the second-1 display element OLED2-1, and the third-1 display element OLED3-1 described above with reference to FIG. 7A, respectively, and thus redundant description thereof may not be repeated hereinafter.

Each of the display elements may include an emission area. For example, the first-3 display element OLED1-3 may include a first-3 emission area EL1-3, the second-3 display element OLED2-3 may include a second-3 emission area EL2-3, and the third-3 display element OLED3-3 may include a third-3 emission area EL3-3. Because the first-3 emission area EL1-3, the second-3 emission area EL2-3, and the third-3 emission area EL3-3 may be the same or substantially the same as (or similar to) the first-1 emission area EL1-1, the second-1 emission area EL2-1, and the third-1 emission area EL3-1 described above with reference to FIG. 7A, respectively, redundant description thereof may not be repeated hereinafter.

The first refractive layer BL1 may be arranged on a display element arranged in the second area DA-2C as described above. The first refractive layer BL1, which is arranged in the second area DA-2C, may include a second aperture area. Planar shapes of the island layers arranged in the respective second aperture areas may be the same or substantially the same as (or similar to) planar shapes of respective second aperture areas, respectively. In addition, edges of the planar shapes of the respective second aperture areas may be spaced apart from edges of the planar shapes of the respective island layers, respectively. The edges of the planar shape of the respective island layers may be spaced apart from the edges of the planar shapes of the second aperture areas respectively corresponding to the island layers and the edges of the planar shapes of the emission areas. In addition, the planar shapes of the island layers may be arranged inside the planar shapes of the emission areas corresponding to the respective island layers and the planar shapes of the respective second aperture areas.

The first refractive layer BL1 may include a first-3 island layer BL1-3 arranged inside a first-3 aperture area SL-3A (i.e., a first-3A aperture area SL-3AA), a second-3 island layer BL2-3 arranged inside a second-3 aperture area SL-3B (i.e., a a second-3A aperture area SL-3BA), and a third-3 island layer BL3-3 arranged inside a third-3 aperture area SL-3C (i.e., a third-3A aperture area SL-3CA). Each of the first-3 island layer BL1-3, the second-3 island layer BL2-3, and the third-3 island layer BL3-3 may be respectively disconnected from the first refractive layer BL1 by the first-3 aperture area SL-3A, the second-3 aperture area SL-3B, and the third-3 aperture area SL-3C, which are the second aperture areas.

The first-3 aperture area SL-3A may include a first-3A aperture area SL-3AA arranged outside of the first-3 island layer BL1-3, and a first-3B aperture area SL-3AB arranged inside the first-3 island layer BL1-3. The first-3A aperture area SL-3AA and the first-3 island layer BL1-3 may each have a ring-shaped planar shape. The planar shape of the first-3 island layer BL1-3 may be arranged inside an outermost edge of the planar shape of the first-3A aperture area SL-3AA. In addition, the first-3B aperture area SL-3AB may have an island-shaped planar shape. The planar shape of the first-3B aperture area SL-3AB may be arranged inside the outermost edge of the planar shape of the first-3 island layer BL1-3. In addition, the first-3B aperture area SL-3AB may be disconnected from the first-3A aperture area SL-3AA.

The second-3 aperture area SL-3B may include a second-3A aperture area SL-3BA and a second-3B aperture area SL-3BB. In addition, the third-3 aperture area SL-3C may include a third-3A aperture area SL-3CA and a third-3B aperture area SL-3CB. Because the second-3 aperture area SL-3B and the third-3 aperture area SL-3C are similar to the first-3 aperture area SL-3A described above, redundant description thereof may not be repeated hereinafter.

A total area of the first aperture area corresponding to one display element arranged in the first area DA-2B may be less than a total area of the second aperture area arranged in the second area DA-2C corresponding to one display area emitting light of a same color as that of the one display element arranged in the first area DA-2B. For example, a total area of a planar shape of the first-2 aperture area SL-2A shown in FIG. 7B may be less than a total area of a planar shape of the first-3 aperture area SL-3A shown in FIG. 7C. A total area of a planar shape of the second-2 aperture area SL-2B may be less than a total area of a planar shape of the second-3 aperture area SL-3B. In addition, a total area of a planar shape of the third-2 aperture area SL-2C may be less than a total area of a planar shape of the third-3 aperture area SL-3C.

In addition, total areas of planar shapes of island layers which are respectively arranged in the display area of the first area and the display area of the second area, in which the display elements emitting light of a same color are arranged, may be different from each other. For example, the total area of the planar shape of the island layer arranged to correspond to the display area of the first area DA-2B may be greater than the total area of the planar shape of the island layer arranged to correspond to the display area of the second area DA-2C. For example, a total area of a planar shape of the first-2 island layer BL1-2 shown in FIG. 7B may be greater than a total area of a planar shape of the first-3 island layer BL1-3 shown in FIG. 7C, and a total area of a planar shape of the second-2 island layer BL2-2 may be greater than a total area of a planar shape of the second-3 island layer BL2-3. In addition, a total area of a planar shape of the third-2 island layer BL3-2 may be greater than a total area of a planar shape of the third-3 island layer BL3-3.

By controlling an amount of refracted light through the difference in areas as described above, a luminance of the light emitted from the respective areas and reflected from the beam splitter may be uniform or substantially uniform.

FIG. 8 is a cross-sectional view schematically illustrating the display elements shown in FIGS. 7A, 7B, and 7C. FIG. 8 show cross-sectional views taken along the line A-A' of FIG. 7A, the line B-B' of FIG. 7B, and the line C-C' of FIG. 7C.

Referring to FIG. 8, the display panel 10 may include the substrate 100, the display layer 200, the encapsulation layer 300, the first refractive layer BL1, and a second refractive layer OL.

The display layer 200 may be arranged on the substrate 100. The display layer 200 may include the pixel circuit layer 210 and the display element layer 220. The pixel circuit layer 210 may include a buffer layer 211, a first gate insulating layer 213, a second gate insulating layer 215, an interlayer insulating layer 217, an organic insulating layer 219, and the pixel circuit PC. The pixel circuit PC may include a thin-film transistor TFT and the storage capacitor Cst. The thin-film transistor TFT may include a semiconductor layer Act, a gate electrode GE, a source electrode SE, and a drain electrode DE.

The buffer layer 211 may be arranged on the substrate 100. The buffer layer 211 may include an inorganic insulating material, such as SiNₓ, SiON, and/or SiO₂, and may be a layer or layers that include one or more of the inorganic insulating materials.

The thin-film transistor TFT may include the semiconductor layer Act, and the semiconductor layer Act may be arranged on the buffer layer 211. The semiconductor layer Act may include polysilicon. As another example, the semiconductor layer Act may include amorphous silicon, an oxide semiconductor, an organic semiconductor, or the like. The semiconductor layer Act may include a channel region, a drain region, and a source region. The drain region and the source region may be respectively arranged at opposite sides of the channel region.

The gate electrode GE may overlap with the channel region. The gate electrode GE may include a low-resistance metal material. The gate electrode GE may include a conductive material, such as, for example, molybdenum (Mo), aluminum (Al), copper (Cu), and/or titanium (Ti), and may include a layer or layers that include one or more of the conductive materials.

The first gate insulating layer 213, which may be between the semiconductor layer Act and the gate electrode GE, may include an inorganic insulating material, such as SiO₂, SiNₓ, SiON, Al₂O₃, TiO₂, Ta₂O₅, hafnium oxide (HfO₂), and/or ZnO.

The second gate insulating layer 215 may be provided to cover the gate electrode GE. Similar to the first gate insulating layer 213, the second gate insulating layer 215 may include an inorganic insulating material, such as SiO₂, SiNₓ, SiON, Al₂O₃, TiO₂, Ta₂O₅, HfO₂, and/or ZnO.

An upper electrode CE2 of the storage capacitor Cst may be arranged above the second gate insulating layer 215. The upper electrode CE2 may overlap with the gate electrode GE, which is below (e.g., under) the upper electrode CE2. The gate electrode GE and the upper electrode CE2, which overlap with each other with the second gate insulating layer 215 between the gate electrode GE and the upper electrode CE2, may constitute the electrodes of the storage capacitor Cst. In other words, the gate electrode GE may function as a lower electrode CE1 of the storage capacitor Cst, and the upper electrode CE2 may be the upper electrode CE2 of the storage capacitor.

In an embodiment, the storage capacitor Cst and the thin-film transistor TFT may be formed to overlap with each other. In some embodiments, the storage capacitor Cst may be formed so as not to overlap with the thin-film transistor TFT.

The upper electrode CE2 may include Al, platinum (Pt), palladium (Pd), silver (Ag), magnesium (Mg), gold (Au), nickel (Ni), neodymium (Nd), iridium (Ir), chrome (Cr), calcium (Ca), Mo, Ti, tungsten (W), and/or Cu, and may include a layer or layers of one or more of the materials.

The interlayer insulating layer 217 may cover the upper electrode CE2. The interlayer insulating layer 217 may include an inorganic insulating material, such as SiO₂, SiNₓ, SiON, Al₂O₃, TiO₂, Ta₂O₅, HfO₂, and/or ZnO. The interlayer insulating layer 217 may be a layer or layers that include one or more of the inorganic insulating materials.

The drain electrode DE and the source electrode SE may be arranged on the interlayer insulating layer 217. The drain electrode DE and the source electrode SE may be electrically connected to the semiconductor layer Act. The drain electrode DE and the source electrode SE may include a suitable material having a conductivity (e.g., having a good conductivity). The drain electrode DE and the source electrode SE may include a conductive material, such as Mo, Al, Cu, and/or Ti, and may include a layer or layers that include one or more of the conductive materials. In an embodiment, the drain electrode DE and the source electrode SE may have a multi-layered structure of Ti/Al/Ti.

The organic insulating layer 219 may be arranged to cover the drain electrode DE and the source electrode SE. The organic insulating layer 219 may include an organic insulating material, such as general-purpose polymers, such as polymethylmethacrylate (PMMA) or polystyrene (PS), polymer derivatives having a phenol-based group, acryl-based polymers, imide-based polymers, aryl ether-based polymers, amide-based polymers, fluorine-based polymers, p-xylene-based polymers, vinyl alcohol-based polymers, and/or any suitable blends thereof. In some embodiments, the organic insulating layer 219 may include a first organic insulating layer and a second organic insulating layer.

The display element layer 220 may be arranged on the pixel circuit layer 210. The display element layer 220 may be arranged on the organic insulating layer 219. The display element layer 220 may include a plurality of organic light-emitting diodes OLED, which are a plurality of display elements. In an embodiment, the display element layer 220 may further include the bank layer 225. For convenience of illustration, the first-1 display element OLED1-1, the first-2 display element OLED1-2, and the first-3 display element OLED1-3, which are respectively arranged in the connection area DA-2A, the first area DA-2B, and the second area DA-2C, are mainly described in more detail below. A relationship between the second-1 display element OLED2-1, the second-2 display element OLED2-2, and the second-3 display element OLED2-3 may be similar to the relationship between the first-1 display element OLED1-1, the first-2 display element OLED1-2, and the first-3 display element OLED1-3. A relationship between the third-1 display element OLED3-1, the third-2 display element OLED3-2, and the third-3 display element OLED3-3 may be similar to the relationship between the first-1 display element OLED1-1, the first-2 display element OLED1-2, and the first-3 display element OLED1-3. Thus, redundant description thereof may not be repeated hereinafter.

The first-1 display element OLED1-1, the first-2 display element OLED1-2, and the first-3 display element OLED1-3 may be arranged on the organic insulating layer 219.

The first-1 display element OLED1-1, the first-2 display element OLED1-2, and the first-3 display element OLED1-3 may emit one of a red light, a green light, or a blue light, or one of a red light, a green light, a blue light, or a white light. Hereinafter, for convenience of illustration, a case in which each of the first-1 display element OLED1-1, the first-2 display element OLED1-2, and the first-3 display element OLED1-3 emit a blue light may be described in more detail as a representative example. In addition, the first-1 display element OLED1-1 will be mainly described in more detail hereinafter, because the first-2 display element OLED1-2 and the first-3 display element OLED1-3 may be the same or substantially the same as (or similar to) the first-1 display element OLED1-1.

The first-1 display element OLED1-1 may include a pixel electrode 221, an intermediate layer 222, and a common electrode 223. The pixel electrode 221 may be electrically connected to the thin-film transistor TFT through a contact hole defined in (e.g., penetrating) the organic insulating layer 219. The pixel electrode 221 may include a conductive oxide, such as indium tin oxide (ITO), indium zinc oxide (IZO), ZnO, In₂O₃, indium gallium oxide (IGO), and/or aluminum zinc oxide (AZO). In another embodiment, the pixel electrode 221 may include a reflective film, including Ag, Mg, Al, Pt, Au, Ni, Nd, Ir, Cr, and/or any suitable compounds thereof. In another embodiment, the pixel electrode 221 may further include a film that includes ITO, IZO, ZnO, and/or In₂O₃, above/below the reflective film. For example, the pixel electrode 221 may have a multi-layered structure of ITO/Ag/ITO.

The bank layer 225 may cover an edge of the pixel electrode 221. The bank layer 225 may have an opening OP defined therein. A central portion of the pixel electrode 221 may be exposed through the opening OP. The opening OP may be defined as an emission area of light emitted from the organic light-emitting diode OLED. In an embodiment, a width of the first-1 emission area EL1-1 in a first direction x may be greater than a width of the first-1 emission area EL1-1 in a second direction y. In an embodiment, the bank layer 225 may include an organic material and/or an inorganic material. In an embodiment, the bank layer 225 may be transparent. In some embodiments, the bank layer 225 may include a black matrix. In this case, the bank layer 225 may be opaque.

The intermediate layer 222 may include a first functional layer 222a, the emission layer 222b, and a second functional layer 222c. The emission layer 222b may include a polymer or a low-molecular weight organic material, which emits light of a desired color (e.g., a certain or predetermined color).

In an embodiment, at least one of the first functional layer 222a or the second functional layer 222c may be a common layer that is arranged entirely over a display area. For example, the first functional layer 222a may include a hole transport layer (HTL), or may include the HTL and a hole injection layer (HIL). The second functional layer 222c may include an electron transport layer (ETL) and/or an electron injection layer (EIL). In some embodiments, the second functional layer 222c may be omitted as needed or desired.

The common electrode 223 may be arranged on the emission layer 222b. The common electrode 223 may include a conductive material that has a low work function. For example, the common electrode 223 may include a (semi-)transparent layer, which includes Ag, Mg, Al, Pt, Pd, Au, Ni, Nd, Ir, Cr, lithium (Li), Ca, and/or any suitable alloys thereof. In some embodiments, the common electrode 223 may further include a layer, such as ITO, IZO, ZnO, AZO, and/or In₂O₃, above the (semi-)transparent layer including one or more of the above-described materials.

In some embodiments, a capping layer may be further arranged on the common electrode 223. The capping layer may include lithium fluoride (LiF), an inorganic material, and/or an organic material.

The encapsulation layer 300 may be arranged on the display element layer 220. The encapsulation layer 300 may cover the first-1 display element OLED1-1, the first-2 display element OLED1-2, and the first-3 display element OLED1-3. In an embodiment, the encapsulation layer 300 may include at least one inorganic encapsulation layer and at least one organic encapsulation layer. FIG. 8 shows that the encapsulation layer 300 includes a first inorganic encapsulation layer 310, an organic encapsulation layer 320, and a second inorganic encapsulation layer 330, which are sequentially stacked.

At least one inorganic encapsulation layer may include one or more inorganic materials among Al₂O₃, TiO₂, Ta₂O₅, HfO₂, ZnO, SiO₂, SiNₓ, and/or SiON. In an embodiment, the first inorganic encapsulation layer 310 may include SiON. The second inorganic encapsulation layer 330 may include SiNₓ.

At least one organic encapsulation layer may include a polymer-based material. The polymer-based material may include an acryl-based resin, an epoxy-based resin, polyimide, polyethylene, or the like. In an embodiment, the at least one organic encapsulation layer may include an acrylate.

In an embodiment, the first refractive layer BL1 and the second refractive layer OL may be in the first display area DA1 and the second display area DA2. The first refractive layer BL1 and the second refractive layer OL may be arranged on the encapsulation layer 300. A refractive index of the first refractive layer BL1 and a refractive index of the second refractive layer OL may be different from each other.

A first refractive index of the first refractive layer BL1 may be in a range of about 1.3 to about 1.6. In an embodiment, the first refractive index of the first refractive layer BL1 may be in a range of about 1.4 to about 1.55. For example, the first refractive layer BL1 may include ethylhexyl acrylate, pentafluoropropyl acrylate, polyethylene glycol dimetharylate, ethylene glycol dimethacrylate, and/or the like. In an embodiment, the first refractive layer BL1 may include an acryl-based organic material having a refractive index of about 1.5. In addition, the first refractive layer BL1 may include a suitable material that forms the organic encapsulation layer 320 of the encapsulation layer 300. In an embodiment, the first refractive layer BL1 may include an epoxy-based organic material, and in some cases, may also include a photocurable material.

The second refractive layer OL may be a planarization layer that has a second refractive index. The second refractive index of the second refractive layer OL may be in a range of about 1.65 to about 1.85. For example, the second refractive layer OL may include polydiarylsiloxane, methyltrimethoxysilane, tetramethoxysilane, and/or the like. In an embodiment, the second refractive layer OL may include an acryl-based and/or siloxane-based organic material, which has a refractive index of about 1.6. In another embodiment, the second refractive layer OL may include dispersed particles for a high refractive index. For example, in the second refractive layer OL, metal oxide particles, such as zinc oxide (ZnOₓ), TiO₂, zirconium dioxide (ZrO₂), and/or barium titanate (BaTiO₃), may be dispersed.

In this case, the first refractive layer BL1 and the second refractive layer OL may be arranged in the same or substantially the same (or similar) shape as each other in a plurality of display areas arranged in respective areas. For convenience of illustration, a case is mainly described in more detail below in which the first refractive layer BL1 and the second refractive layer OL are arranged on the first-1 display element OLED1-1 arranged in the connection area DA-2A, the first-2 display element OLED1-2 arranged in the first area DA-2B, and the first-3 display element OLED1-3 arranged in the second area DA-2C.

The first refractive layer BL1 may be arranged over an entire upper surface of the display element in the connection area DA-2A, and may not have an aperture area. For example, the first refractive layer BL1 may be arranged to completely shield an upper surface of the first-1 display element OLED1-1.

The first refractive layer BL1 arranged in the first area DA-2B and the second area DA-2C may include an island layer, a first aperture area, and a second aperture area, as described above. For example, the first-2 island layer BL1-2 and the first-2 aperture area SL-2A may be provided in a portion of the first refractive layer BL1 corresponding to the first-2 emission area EL1-2. The first refractive layer BL1 and the first-2 island layer BL1-2, which are arranged around the first-2 aperture area SL-2A, may have a first-2 inclined surface BL1-2A in which the first-2 aperture area SL-2A is defined. In addition, the first-3 island layer BL1-3 and the first-3 aperture area SL-3A may be arranged in a portion of the first refractive layer BL1 corresponding to the first-3 emission area EL1-3. The first-3A aperture area SL-3AA may be defined outside the first-3 island layer BL1-3, and the first-3B aperture area SL-3AB may be arranged inside the first-3 island layer BL1-3. In this case, the first refractive layer BL1 and the first-3 island layer BL1-3, which are arranged around the first-3 aperture area SL-3A, may have a first-3 inclined surface BL1-3A.

In this case, a first-2 inclination angle θ1-1 of the first-2 inclined surface BL1-2A and a first-3 inclination angle θ2-1 of the first-3 inclined surface BL1-3A may be different from each other. For example, the first-2 inclination angle θ1-1 may be less than the first-3 inclination angle θ2-1.

In this case, light emitted from the first-2 display element OLED1-2 may travel in a straight or substantially straight line. Due to a difference in the refractive index between the first-2 inclined surface BL1-2A and the first refractive layer BL1 and the second refractive layer OL, at least some of the light emitted from the first-2 display element OLED1-2 may vary so that a path of the light has a first-2 refractive angle θ1-2. In addition, due to a difference in the refractive index between the first-3 inclined surface BL1-3A and the first refractive layer BL1 and the second refractive layer OL, at least some of the light emitted from the first-3 display element OLED1-3 may vary so that a path of the light has a first-3 refractive angle θ2-2. Each of the refractive angles may indicate an angle between a path on which light travels in a straight line and a traveling direction of light on a changed path. In this case, the first-2 refractive angle θ1-2 may be less than the first-3 refractive angle θ2-2.

When the first area DA-2B and the second area DA-2C do not include an aperture area, light emitted from the display elements arranged in the first area DA-2B and the second area DA-2C may travel in a straight or substantially straight line, and some of the light emitted from the display elements arranged in the first area DA-2B and the second area DA-2C may not be transferred to the user due to an inclination of a reflection surface of the beam splitter. However, by arranging the island layer and the aperture area in the first area DA-2B and the second area DA-2C as described above, a path of at least some of the light emitted from the display elements arranged in the first area DA-2B and the second area DA-2C may be changed so that an area may be increased in which the light emitted from the display elements arranged in the first area DA-2B and the second area DA-2C may be reflected by the beam splitter. For example, by refracting light emitted from side portions of the display elements arranged in the first area DA-2B and the second area DA-2C, some of the light emitted from the display elements arranged in the first area DA-2B and the second area DA-2C may be transmitted as close as possible to an area of the beam splitter where light emitted from the connection area DA-2A is reflected. In addition, by varying a refractive angle of at least some of the light emitted from the first area DA-2B and allowing a refractive angle of the light emitted from the second area DA-2C to be greater than the refractive angle of the light emitted from the first area DA-2B, a luminance of the light emitted from the connection area DA-2A, the first area DA-2B, and the second area DA-2C may become nearly similar or uniform. In this case, when an image implemented in the second display area DA2 is reflected from the beam splitter and seen by the user, the user may hardly feel a difference in the luminance of the image implemented in the second display area DA2.

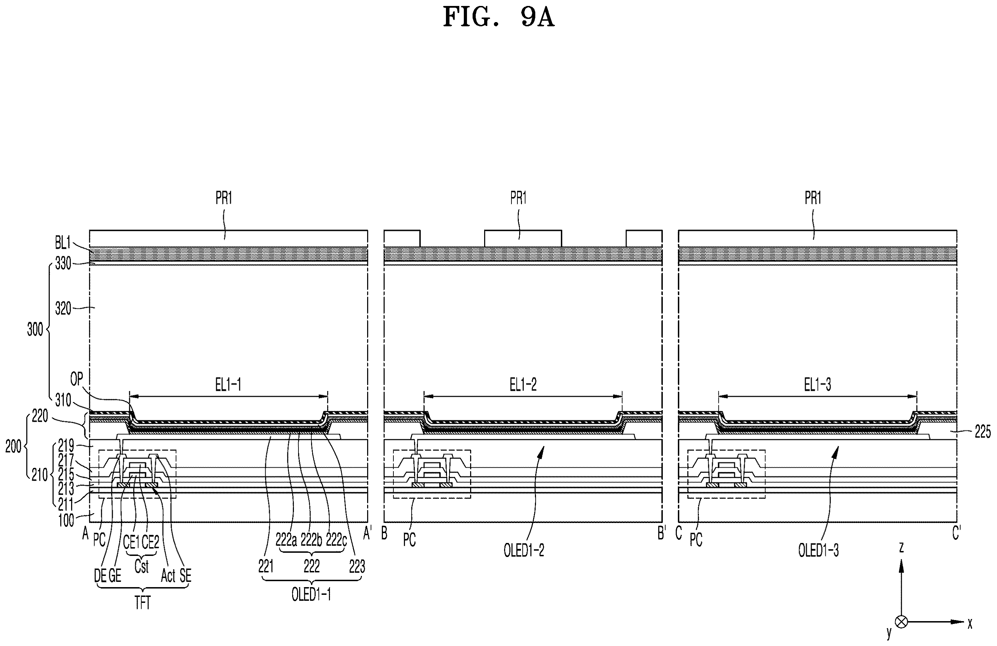

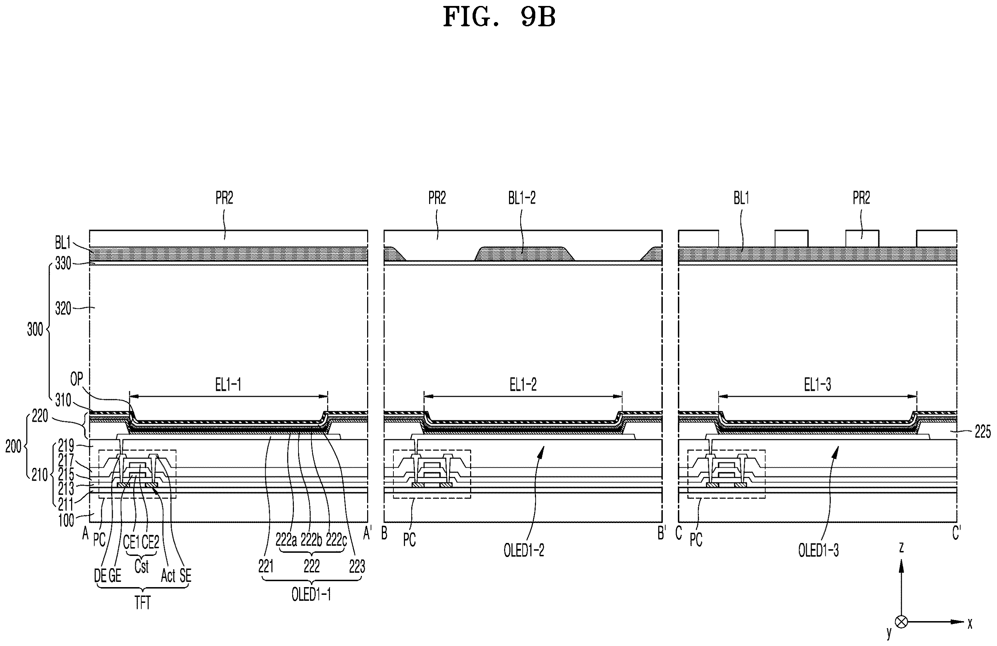

FIGS. 9A and 9B are cross-sectional views schematically illustrating an order of a method of manufacturing the display panel shown in FIG. 8.

Referring to FIGS. 9A and 9B, the pixel circuit layer 210, the display element layer 220 and the encapsulation layer 300 may be arranged on the substrate 100, and then the first refractive layer BL1 may be arranged on the encapsulation layer 300. The pixel circuit layer 210, the display element layer 220 and the encapsulation layer 300 may be the same or substantially the same as (or similar to) those described above with reference to FIG. 8, and thus, redundant description thereof may not be repeated hereinafter. In addition, reference symbols of FIGS. 9A and 9B, which are the same as those used in FIG. 8, denote the same or substantially the same elements or members as those described above with reference to FIG. 8.

When the first refractive layer BL1 is arranged, a first photoresist PR1 may be coated on the first refractive layer BL1, and a pattern may be formed. The pattern of the first photoresist PR1 may be arranged only in a portion corresponding to the first area DA-2B, and the connection area DA-2A and the second area DA-2C may be completely shielded. Thereafter, the first refractive layer BL1 may be etched to form an aperture area and an island layer in the first area DA-2B. In addition, an inclined surface, which is the same or substantially the same as (or similar to) the first-2 inclined surface BL1-2A described above with reference to FIG. 8, may be formed in at least one of the first refractive layer BL1 or the island layer, which correspond to the aperture area arranged in the first area DA-2B. For etching, dry etching, which uses laser, plasma gas, or the like, or wet etching, which uses an etchant, may be used.

When the process described above is completed, the first photoresist PR1 may be removed, and a second photoresist PR2 may be coated, as shown in FIG. 9B. Thereafter, the second photoresist PR2 may be exposed and developed to form a pattern in the second area DA-2C. In addition, the first refractive layer BL1 arranged in the second area DA-2C may be etched according to the pattern in the second photoresist PR2. An inclined surface, which is the same or substantially the same as (or similar to) the first-3 inclined surface BL1-3A described above with reference to FIG. 8, may be formed in at least one of the first refractive layer BL1 or the island layer, which correspond to the aperture area arranged in the second area DA-2C. For etching, dry etching, which uses laser, plasma gas, or the like, or wet etching, which uses an etchant, may be used. In this case, by changing an etchant, an etching method, and/or an etching process condition in the etching method, which is used for forming the aperture area and the island layer in the first area DA-2B, an inclination angle of the inclined surface arranged in the first area DA-2B and an inclination angle of the inclined surface arranged in the second area DA-2C may become different from each other. By arranging the second photoresist PR2 to completely shield the connection area DA-2A and the first area DA-2B, the island layer and the aperture area, which are formed in the first area DA-2B, may not be changed.

When the process described above is completed, the second photoresist PR2 may be removed, and the second refractive layer OL may be arranged on the first refractive layer BL1 in an inkjet manner. In this case, the second refractive layer OL may be coated on the inside of the aperture area formed in the first refractive layer BL1 and on the first refractive layer BL1.

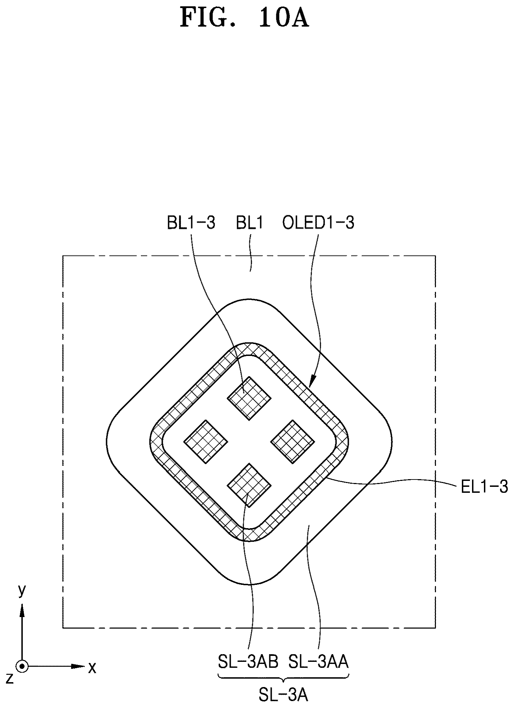

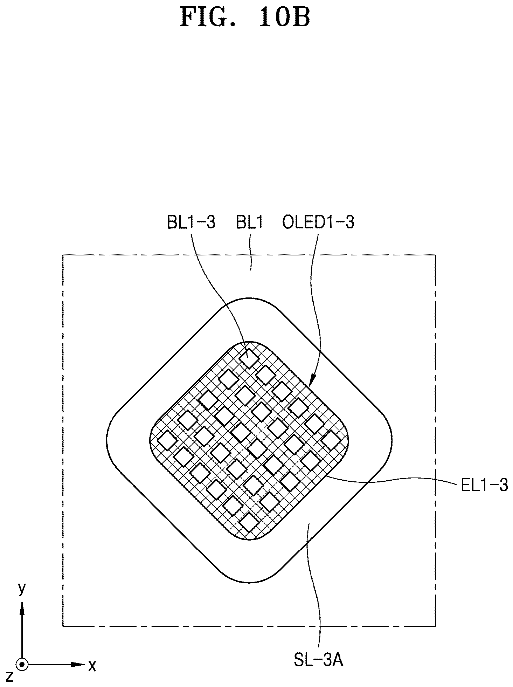

FIGS. 10A and 10B are plan views schematically illustrating the first-3 emission area EL1-3 of a first-3 display element OLED1-3 and the first refractive layer, which are arranged in the second area DA-2C of the display panel, according to some embodiments.

Referring to FIG. 10A, the first-3 emission area EL1-3 of the first-3 display element OLED1-3 may be arranged to overlap with the first-3 aperture area SL-3A. In a plan view, the first-3 aperture area SL-3A may include the first-3A aperture area SL-3AA in which the first-3 emission area EL1-3 is arranged, and a first-3B aperture area SL-3AB arranged in the first-3 emission area EL1-3. In a plan view, the first-3 island layer BL1-3 may be arranged inside the first-3 emission area EL1-3. In addition, the first-3B aperture area SL-3AB may be arranged in the first-3 island layer BL1-3. The first-3B aperture area SL-3AB may be provided in a plurality, and the plurality of first-3B aperture areas SL-3AB may be spaced apart from each other. At least a portion of the first-3 island layer BL1-3 may be formed in a lattice shape.

In this case, at least some of the first refractive layer BL1 or the first-3 island layer BL1-3, which are arranged around the first-3 aperture area SL-3A, may include an inclined surface. The inclined surface may have a shape that is the same or substantially the same as (or similar to) that shown in FIG. 8.

In some embodiments, the first refractive layer BL1 arranged on the display elements arranged in the second area DA-2C may be formed similarly to the structure shown in FIG. 10A.

Referring to FIG. 10B, the first-3 aperture area SL-3A may be formed similarly to the first-3A aperture area SL-3AA described above with reference to FIG. 10A. The first-3 island layer BL1-3 may be provided in a plurality, and the plurality of first-3 island layers BL1-3 may be spaced apart from each other. The plurality of first-3 island layers BL1-3 may be arranged to overlap with the first-3 emission area EL1-3. In this case, light emitted from the first-3 display element OLED1-3 may be refracted in a plurality of areas.

At least a portion of the first-3 aperture area SL-3A may form a lattice shape. In addition, at least some of the first refractive layer BL1 or the first-3 island layer BL1-3, which are arranged around the first-3 aperture area SL-3A, may include an inclined surface. The inclined surface may have a shape that is the same or substantially the same as (or similar to) that shown in FIG. 8.

In some embodiments, the first refractive layer BL1 arranged on the display elements arranged in the second area DA-2C may be formed similarly to the structure shown in FIG. 10B.

In the structure shown in FIGS. 10A and 10B, a total area of a planar shape of the aperture area arranged in the first area DA-2B and corresponding to the display element arranged in the first area DA-2B may be less than a total area of a planar shape of the aperture area corresponding to the display element arranged in the second area DA-2C, which emits light of the same color as that of the display element arranged in the first area DA-2B. The total area may indicate a sum of the planar shapes of all of the aperture areas that correspond to one display element. In addition, the total area of the planar shape of the island layer arranged in the first area DA-2B and corresponding to the display element arranged in the first area DA-2B may be greater than the total area of the planar shape of the island layer corresponding to the display element arranged in the second area DA-2C that emits light of the same color as that of the display element arranged in the first area DA-2B. The total area may indicate a sum of the planar shapes of all of the island layers corresponding to one display element. For example, the number of island layers that are arranged in the first area DA-2B and corresponding to the display elements emitting light of the same color as each other may be less than the number of first-3B aperture areas SL-3AB shown in FIG. 10A. In addition, the island layers that are arranged in the first area DA-2B and corresponding to the display elements emitting light of the same color as each other may have a greater area than the first-3 island layers BL1-3 shown in FIG. 10B, while being less in number. For example, the island layer arranged in the first area DA-2B may have a shape that connects four adjacent outer edges among the first-3 island layer BL1-3 shown in FIG. 10B to each other.

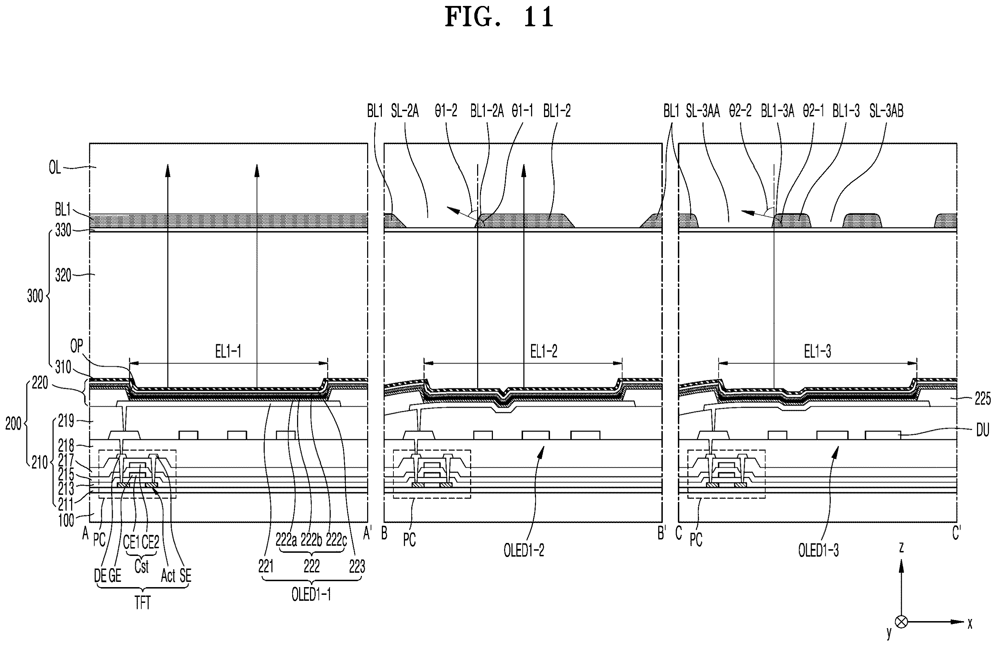

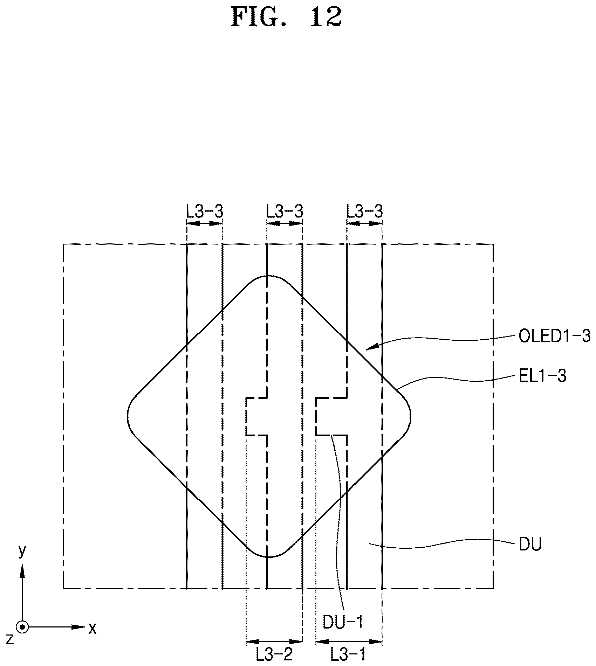

FIG. 11 is a cross-sectional view schematically illustrating a portion of a display panel according to an embodiment. FIG. 12 is a plan view schematically illustrating locations of an emission area and a wiring, which are arranged in the second area DA-2C of the display panel shown in FIG. 11. In FIG. 11, the lines A-A', B-B', and C-C' indicate cross-sectional lines of a first emission area (e.g., the first-1 emission area EL1-1), a second emission area (e.g., the first-2 emission area EL1-2), and a third emission area (e.g., the first-3 emission area EL1-3), similar to those described above with reference to FIG. 8.

Referring to FIGS. 11 and 12, the display panel 10 may include the substrate 100, the display layer 200, the encapsulation layer 300, the first refractive layer BL1, and the second refractive layer OL.

The display layer 200 may be arranged on the substrate 100. The display layer 200 may include a pixel circuit layer 210 and a display element layer 220. The pixel circuit layer 210 may include the buffer layer 211, the first gate insulating layer 213, the second gate insulating layer 215, an interlayer insulating layer 217, the organic insulating layer 219, and the pixel circuit PC. The pixel circuit PC may include the thin-film transistor TFT and the storage capacitor Cst. The thin-film transistor TFT may include the semiconductor layer Act, the gate electrode GE, the source electrode SE, and the drain electrode DE. The display element layer 220 may be arranged on the pixel circuit layer 210. The display element layer 220 may be arranged on the organic insulating layer 219. The display element layer 220 may include a plurality of organic light-emitting diodes OLED, which are a plurality of display elements. In an embodiment, the display element layer 220 may further include the bank layer 225. The substrate 100, the display layer 200, the encapsulation layer 300, the first refractive layer BL1, and the second refractive layer OL may be the same or substantially the same as (or similar to) those described above with reference to FIG. 8, and thus, redundant description thereof may not be repeated, and the differences from those of FIG. 8 may be mainly described in more detail below.

The display panel 10 may further include an additional organic insulating layer 218 between the interlayer insulating layer 217 and the organic insulating layer 219. The additional organic insulating layer 218 may include a material that is the same or substantially the same as (or similar to) that of the organic insulating layer 219. In addition, the pixel electrode 221 may be connected to the drain electrode DE through a separate connection electrode.

The display panel 10 may include a wiring DU in a layer in which the connection electrode is arranged. The wiring DU may be arranged between the organic insulating layer 219 and the additional organic insulating layer 218. In another embodiment, in the structure as shown in FIG. 8, the wiring DU may be arranged between the organic insulating layer 219 and the interlayer insulating layer 217.

The wiring DU may include various suitable wirings. For example, the wiring DU may be a wiring that delivers voltages or various signals when a display element is operated, such as a data line, a scan line, a common voltage line, a driving voltage line, or an initialization voltage line.

The wiring DU may be provided in a plurality, and at least some of the plurality of wirings DU may be arranged to overlap with a pixel electrode of a display element.

Referring to FIGS. 11 and 12, second widths L3-3 of the plurality of wirings DU, which overlap with the pixel electrode 221 of the first-1 display element OLED1-1, may be equal to or substantially equal to each other. On the other hand, a width of at least a portion of one of the plurality of wirings DU that overlap with a pixel electrode of the first-2 display element OLED1-2 may be different from a width of at least a portion of another one of the plurality of wirings DU that overlap with the pixel electrode of the first-2 display element OLED1-2. In addition, a width of at least a portion of one of the plurality of wirings DU that overlap with a pixel electrode of the first-3 display element OLED1-3 may be different from a width of at least a portion of another one of the plurality of wirings DU that overlap with the pixel electrode of the first-3 display element OLED1-3. In this case, the plurality of wirings DU that overlap with the first-2 display element OLED1-2 and the plurality of wirings DU that overlap with the first-3 display element OLED1-3 may have similar tendencies as each other. Accordingly, for convenience of illustration, the plurality of wirings DU that overlap with the first-3 display element OLED1-3 may be mainly described in more detail below.

Referring to FIGS. 11 and 12, some of the plurality of wirings DU may be arranged to pass through (e.g., may extend across) the first-3 emission area EL1-3. The second widths L3-3 of the plurality of wirings DU that pass through the first-3 emission area EL1-3 may be the same or substantially the same as each other. In addition, at least one of the plurality of wirings DU that pass through the first-3 emission area EL1-3 of the first-3 display element OLED1-3 may include a first protrusion DU-1 protruding toward the first-3 emission area EL1-3. Widths L3-1 and L3-2 of portions of the wiring DU in which the first protrusion DU-1 is formed may be greater than the second width L3-3 of another portion of the wiring DU. For example, as illustrated in FIG. 12, the first width L3-1 of a portion of the wiring DU in which the first protrusion DU-1 is formed may be greater than the second width L3-3 of the wiring DU in which the first protrusion DU-1 is not formed.

When at least two of the plurality of wirings DU passing through the first-3 emission area EL1-3 have the first protrusion DU-1, widths of the first protrusions DU-1 may be equal to or substantially equal to each other, or may be different from each other. For example, as illustrated in FIG. 12, a third width L3-2 of the first protrusion DU-1 of the wiring DU, which is arranged in the center, may be less than the first width L3-1 of the first protrusion DU-1 of the wiring DU arranged on the right side. In this case, a slope may be formed on an upper surface of a layer (e.g., the organic insulating layer 219 of FIG. 11) arranged on the wiring DU toward the left in FIG. 12. For example, the slope may be formed in a shape where a right side thereof is higher and a left side thereof is lower, as shown in FIG. 12. In this example, the right side of FIG. 12 may be relatively closer to the user UR illustrated in FIG. 3A, and the left side of FIG. 12 may be relatively closer to the first area DA-2B. The structure as described above may also be applicable to the display elements arranged in the first area DA-2B. In this case, a protrusion of the wiring DU arranged in the first area DA-2B may be formed the same or substantially the same as the first protrusion DU-1 arranged in the second area DA-2C, or may be formed to be less in width than that of the first protrusion DU-1 arranged in the second area DA-2C. In the structure as described above, an upper surface of at least a portion of a layer arranged on the wiring DU may be formed to be inclined, or the layer arranged on the wiring DU may be formed to be inclined in one direction. An inclination direction may be the same or substantially the same as (or similar to) that described above. For convenience of illustration, a case is mainly described in more detail below in which a slope is arranged only in a portion of the layer arranged on the wiring DU.

As described above, by forming at least a portion of the pixel electrode 221 to be inclined through a protrusion, such as the first protrusion DU-1, and by inclining at least a portion of the intermediate layer 222 and the common electrode 223, which are sequentially stacked on the pixel electrode 221, light emitted from the first-3 display element OLED1-3 may be transmitted at a desired angle (e.g., a certain or predetermined angle) with respect to an upper surface of the substrate 100.

In this case, in some embodiments, when the wiring DU arranged in the first area DA-2B does not include a protrusion, the first refractive layer BL1 arranged in the first area DA-2B may be arranged on an entire surface of the first area DA-2B, similar to that of the first refractive layer BL1 arranged in the connection area DA-2A.

As described above, the wiring DU may not include a protrusion. For example, a width of one of wiring that passes through the display elements may be different from a width of another one of the wiring passing through the display elements. In this case, a width of each wiring may decrease as a distance from the connection area DA-2A decreases, and may increase as a distance from the connection area DA-2A increases.

As described above, a slope arranged in the display elements may be formed in the pixel electrodes of the display elements arranged in the first area DA-2B and the second area DA-2C. For example, the pixel electrode of the display element arranged in the first area DA-2B may have a somewhat flat shape by not overlapping with the wiring DU or by not having the wiring DU have a protrusion. On the other hand, the pixel electrode of the display element arranged in the second area DA-2C may have a slope by overlapping with the wiring DU and by having the wiring DU have a protrusion. In another embodiment, both the pixel electrode of the display element arranged in the first area DA-2B and the pixel electrode of the display element arranged in the second area DA-2C may have a slope. For example, as shown in FIG. 11, the pixel electrode of the first-2 display element OLED1-2 arranged in the first area DA-2B and the pixel electrode of the first-3 display element OLED1-3 arranged in the second area DA-2C may have a slope. In this case, the slope of the pixel electrode of the first-2 display element OLED1-2 may be gentler than the slope of the pixel electrode of the first-3 display element OLED1-3. Such a relationship may be applicable to all display elements that are respectively arranged in the first area DA-2B and the second area DA-2C, and emit light of the same color as each other. As such, an island layer and the aperture area may be obtained.

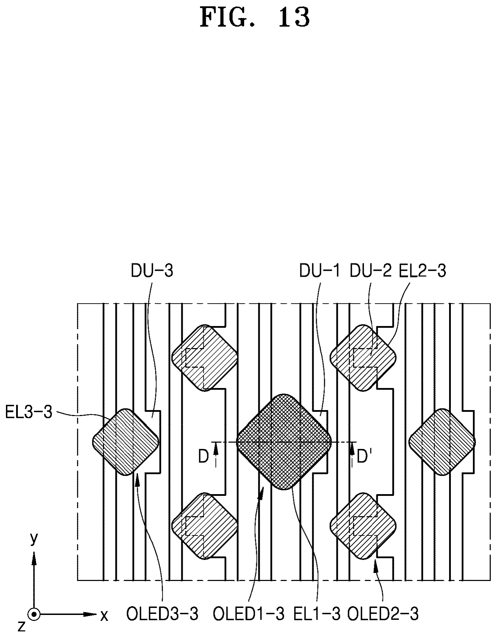

FIG. 13 is a plan view schematically illustrating a portion of a display panel according to an embodiment.

Referring to FIG. 13, a plurality of wirings DU arranged in a second area may include a protrusion. In this case, the wiring DU passing through an emission area of a same display element among the plurality of wirings DU may be arranged to be symmetrical or substantially symmetrical with respect to a center of the emission area.

One of the wirings DU that passes through the first-3 emission area EL1-3 of the first-3 display element OLED1-3 may include the first protrusion DU-1. In this case, the first protrusion DU-1 may protrude to the right of the wiring DU, so that at least a portion of the right portion of the pixel electrode corresponding to the first-3 emission area EL1-3 may be arranged at a higher position than the left part. In an embodiment, the first protrusion DU-1 may protrude in a direction different from a longitudinal direction of one of the wirings DU.

One of the wirings DU that passes through the second-3 emission area EL2-3 of the second-3 display element OLED2-3 may include a second protrusion DU-2. The second protrusion DU-2 may protrude to the left of the wiring DU. The second protrusion DU-2 may be formed in a 'T' shape, and may be connected to the wiring DU. In this case, the second protrusion DU-2 may be provided, such that at least a portion of the pixel electrode corresponding to the second-3 emission area EL2-3, which overlaps with the second protrusion DU-2, may be higher than a portion of the pixel electrode that does not overlap with the second protrusion DU-2. In some embodiments, the second protrusion DU-2 may connect two adjacent wirings DU to each other.

One of the wirings DU that passes through the third-3 emission area EL3-3 of the third-3 display element OLED3-3 may include a third protrusion DU-3. In this case, the third protrusion DU-3 may protrude to the right of the wiring DU, so that at least a portion of the right portion of the pixel electrode corresponding to the third-3 emission area EL3-3 may be higher than the left part.

Through the structure described above, a pixel electrode, an intermediate layer, and a common electrode of the display element arranged in the second area DA-2C may be arranged in an inclined portion, so that the display element may emit light in such a way that at least some of the light form a desired angle (e.g., a certain or predetermined angle) with respect to one surface of the substrate 100.

The structure described above may be applied the same or substantially the same as (or similar to) to the display elements arranged in the first area DA-2B.

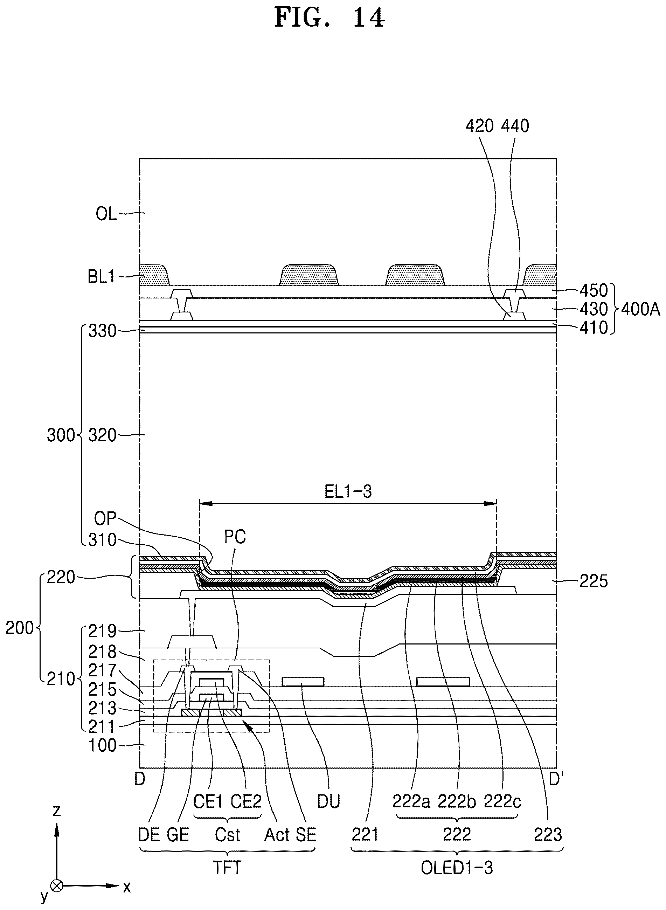

FIG. 14 is a cross-sectional view taken along the line D-D' of FIG. 13.

Referring to FIG. 14, the display panel 10 may include the substrate 100, the display layer 200, the encapsulation layer 300, an input detection layer 400A, which is a first layer 400a among the functional layers 400 shown in FIGS. 5A and 5B, the first refractive layer BL1, and the second refractive layer OL.

The display layer 200 may be arranged on the substrate 100. The display layer 200 may include a pixel circuit layer 210 and a display element layer 220. The pixel circuit layer 210 may include a buffer layer 211, a first gate insulating layer 213, a second gate insulating layer 215, an interlayer insulating layer 217, an organic insulating layer 219, and the pixel circuit PC. The pixel circuit PC may include a thin-film transistor TFT and the storage capacitor Cst. The thin-film transistor TFT may include a semiconductor layer Act, a gate electrode GE, a source electrode SE, and a drain electrode DE. The display element layer 220 may be arranged on the pixel circuit layer 210. The display element layer 220 may be arranged on the organic insulating layer 219. The display element layer 220 may include a plurality of organic light-emitting diodes OLED, which are a plurality of display elements. In an embodiment, the display element layer 220 may further include the bank layer 225. The substrate 100, the display layer 200, the encapsulation layer 300, the first refractive layer BL1, and the second refractive layer OL may be the same or substantially the same as (or similar to) those described above with reference to FIG. 8, and thus, redundant description thereof may not be repeated hereinafter, and parts that are different from those described above with reference to FIG. 8 may be mainly described in more detail below.

The input detection layer 400A may be arranged on the encapsulation layer 300. The input detection layer 400A may include touch electrodes arranged in the display area DA, and at least one touch insulating layer. For example, FIG. 14 shows that the input detection layer 400A includes a first touch insulating layer 410, which is on the second inorganic encapsulation layer 330, a first conductive line 420, which is on the first touch insulating layer 410, a second touch insulating layer 430, which is on the first conductive line 420, a second conductive line 440, which is on the second touch insulating layer 430, and a third touch insulating layer 450, which is on the second conductive line 440.

Each of the first touch insulating layer 410, the second touch insulating layer 430, and the third touch insulating layer 450 may include an inorganic insulating material and/or an organic insulating material. In an embodiment, the first touch insulating layer 410 and the second touch insulating layer 430 may include an organic insulating material, such as silicon oxide, silicon nitride, and/or silicon oxynitride, and the third touch insulating layer 450 may include an organic insulating material.

A touch electrode of the input detection layer 400A may include a structure in which the first conductive line 420 and the second conductive line 440 are connected to each other. In some embodiments, the touch electrode may include either the first conductive line 420 or the second conductive line 440, in which case the second conductive line 440 may be omitted as needed or desired.

Each of the first conductive line 420 and the second conductive line 440 may include Al, Cu, and/or Ti, and may include a layer or layers that include one or more of the materials described above. For example, each of the first conductive line 420 and the second conductive line 440 may have a three-layered structure of Ti layer/Al layer/Ti layer.

The first refractive layer BL1 and the second refractive layer OL may be arranged on the input detection layer 400A. The first refractive layer BL1 may be arranged similarly to that described above with reference to FIGS. 7A to 9B in the connection area DA-2A, the first area DA-2B, and the second area DA-2C.

The display panel 10 may further include the additional organic insulating layer 218 and the wiring DU. The wiring DU may be formed the same or substantially the same as (or similar to) that described above with reference to FIGS. 11 to 14. The wiring DU may have a protrusion so that at least a portion of at least one of the pixel electrodes arranged in the first area DA-2B and/or the second area DA-2C may be inclined. In an embodiment, the slope of at least the portion of the pixel electrode may increase toward the second area DA-2C from the first area DA-2B.

The above-described structure of the display panel 10 may vary, for each area, a range of light emitted from each area of the bent second display area. The electronic apparatus 1 may include the display panel 10 so that a range of light reflected from the beam splitter varies for each area of the second display area, thereby providing images of a uniform or substantially uniform luminance to users.

In a display panel and an electronic apparatus according to one or more embodiments, the luminance of an entire image may be increased when the image is reflected.

In addition, in the display panel and the electronic apparatus according to one or more embodiments, the luminance between a reflected image and transmitted image may be uniform or substantially uniform.

In a vehicle according to an embodiment, vivid images may be provided from the inside or the outside.

The foregoing is illustrative of some embodiments of the present disclosure, and is not to be construed as limiting thereof. Although some embodiments have been described, those skilled in the art will readily appreciate that various modifications are possible in the embodiments without departing from the scope of the present disclosure. It will be understood that descriptions of features or aspects within each embodiment should typically be considered as available for other similar features or aspects in other embodiments, unless otherwise described. Thus, as would be apparent to one of ordinary skill in the art, features, characteristics, and/or elements described in connection with a particular embodiment may be used singly or in combination with features, characteristics, and/or elements described in connection with other embodiments unless otherwise specifically indicated. Therefore, it is to be understood that the foregoing is illustrative of various example embodiments and is not to be construed as limited to the specific embodiments disclosed herein, and that various modifications to the disclosed embodiments, as well as other example embodiments, are intended to be included within the scope of the present disclosure as defined in the appended claims.

## Claims

1. A display panel (10) comprising:
a substrate (100) comprising:
a first display area (DA1); and
a second display area (DA2) connected to the first display area (DA1) at a predetermined angle therebetween;
a plurality of display elements (OLED1-1 to OLED1-3) spaced from each other in the first display area (DA1) and the second display area (DA2);
an encapsulation layer (300) on the plurality of the display elements (OLED1-1 to OLED1-3);
a first refractive layer (BL1) in the first display area (DA1) and the second display area (DA2), the first refractive layer (BL1) being on the encapsulation layer (300); and
a second refractive layer (OL) on the first refractive layer (BL1), the second refractive layer (OL) having a refractive index different from a refractive index of the first refractive layer (BL1),
wherein the second display area (DA2) comprises a first area (DA-2B), and a second area (DA-2C) adjacent to the first area (DA-2B),
wherein the first refractive layer (BL1) in the first area (DA-2B) comprises a first inclined surface, and the first refractive layer (BL1) in the second area (DA-2C) comprises a second inclined surface, and
wherein a first inclination angle (θ1-2) of the first inclined surface is less than a second inclination angle (θ2-2) of the second inclined surface.

2. The display panel (10) of claim 1, wherein at least one of the first refractive layer (BL1) in the first area (DA-2B) or the first refractive layer (BL1) in the second area (DA-2C) comprises an aperture area.

3. The display panel (10) of claim 2, wherein the aperture area comprises:
a first aperture area in the first refractive layer (BL1), and corresponding to one display element in the first area (DA-2B) from among the plurality of display elements (OLED1-1 to OLED1-3); and
a second aperture area in the first refractive layer (BL1), the second aperture area corresponding to one display element in the second area (DA-2C) from among the plurality of display elements (OLED1-1 to OLED1-3).

4. The display panel (10) of claim 3, wherein a total area of a planar shape of the first aperture area is less than a total area of a planar shape of the second aperture area, and/or
wherein an outermost edge of the first aperture area is outside an edge of an emission area of the one display element corresponding to the first aperture area, and/or
wherein an outermost edge of the second aperture area is outside an edge of the one display element corresponding to the second aperture area, and/or
wherein the second aperture area comprises a second-1 aperture area and a second-2 aperture area (SL-2B), the second-2 aperture area (SL-2B) being inside the first refractive layer (BL1) in the second-1 aperture area.

5. The display panel (10) of any of claims 2 to 4, wherein a planar shape of the aperture area comprises an island shape or a lattice shape.

6. The display panel (10) of any of claims 1 to 5, wherein at least one of the first refractive layer (BL1) having the first inclined surface or the first refractive layer (BL1) having the second inclined surface comprises an island shape.

7. The display panel (10) of any of claims 1 to 6, wherein the first area (DA-2B) extends from a point spaced from a boundary between the first display area (DA1) and the second display area (DA2) by 20 % of a total length of the second display area (DA2), to a point spaced from the boundary between the first display area (DA1) and the second display area (DA2) by 55 % of the total length of the second display area (DA2).

8. The display panel (10) of any of claims 1 to 6, wherein the second area (DA2) extends from a point spaced from a boundary between the first display area (DA1) and the second display area (DA2) by 55 % of a total length of the second display area (DA2), to an end of an edge of the second display area (DA2).

9. The display panel (10) of any of claims 1 to 8, wherein the refractive index of the first refractive layer (BL1) is in a range of about 1.4 to about 1.55, and/or
wherein the refractive index of the second refractive layer (OL) is in a range of about 1.65 to about 1.85.

10. The display panel (10) of any of claims 1 to 9, further comprising an input detection layer (400A) between the encapsulation layer (300) and the first refractive layer (BL1).

11. The display panel (10) of any of claims 1 to 10, further comprising a plurality of wirings (DU) between the substrate (100) and a display element from among the plurality of display elements (OLED1-1 to OLED1-3),
wherein at least one of the plurality of wirings (DU) is located on the substrate (100), and at least a portion of a pixel electrode (221) of the display element (OLED1-1 to OLED1-3) is inclined.

12. The display panel (10) of claim 11, wherein a slope of at least the portion of the pixel electrode (221) increases toward the second area (DA-2C) from the first area (DA-2B).

13. The display panel (10) of claim 11 or 12, wherein one of the plurality of wirings (DU) overlapping with the pixel electrode (221) comprises a protrusion (DU-1) protruding in a direction different from a longitudinal direction of the one of the plurality of wirings (DU).

14. An electronic apparatus (1) comprising:
a display panel (10) that is bendable; and
a beam splitter (3) on the display panel (10), and configured to:
transmit a first image implemented in a portion of the display panel (10); and
reflect a second image implemented in another portion of the display panel (10), wherein the display panel (10) is the display panel (10) of any of claims 1 to 13.

15. A vehicle (1000) comprising:
a vehicle (1000) body; and
an electronic apparatus located within the vehicle (1000) body, and comprising a display panel (10),
wherein the electronic apparatus is the electronic apparatus of claim 14, or
wherein the display panel (10) is the display panel (10) of any of claims 1 to 13.
